# EUROPEAN PATENT APPLICATION

(11) **EP 4 417 615 A1**
(43) Date of publication of application: **21.08.2024**
(21) Application number: 22880808.5
(22) Date of filing: 30.09.2022
(51) Int. Cl.: C07F 15/00, C07D 213/16, C07D 213/84, C07D 263/32, C07D 239/26, C07D 277/22, G09F 9/30, H10K 59/00, H10K 50/00

(54) **ORGANIC COMPOUND AND ORGANIC LIGHT-EMITTING ELEMENT**

(30) Priority: 11.10.2021 JP 2021166627
(71) Applicant: CANON KABUSHIKI KAISHA, Tokyo 146-8501 (JP)
(72) Inventor: YAMADA Naoki, Tokyo 146-8501 (JP); KAMATANI Jun, Tokyo 146-8501 (JP); IWAWAKI Hironobu, Tokyo 146-8501 (JP); OHRUI Hiroki, Tokyo 146-8501 (JP); NISHIDE Yosuke, Tokyo 146-8501 (JP); MIYASHITA Hirokazu, Tokyo 146-8501 (JP)
(74) Representative: TBK
(86) International application number: PCT/JP2022/036681
(87) International publication number: WO 2023/063112

(57) **Abstract**

The present disclosure provides an organic compound represented by general formula [1]. 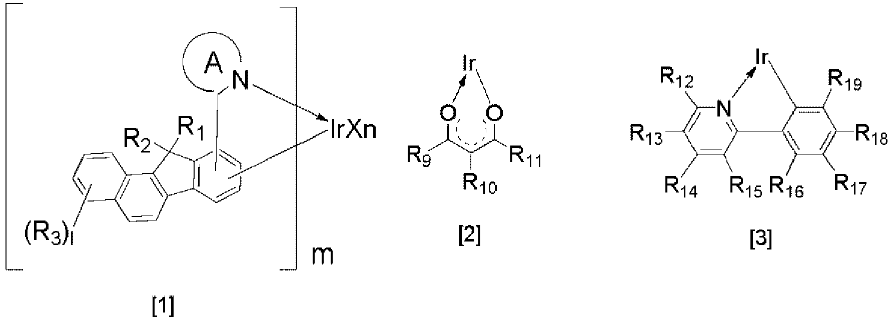 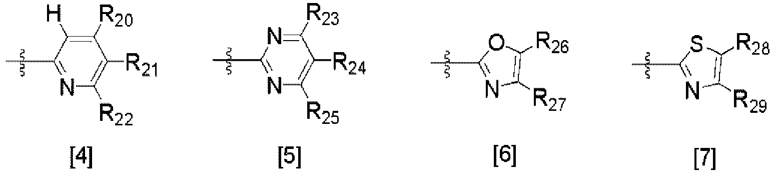 In formula [1], R₁ and R₂ are each independently selected from a hydrogen atom, an alkyl group, and so forth. Each R₃ is independently selected from a deuterium atom, an alkyl group, and so forth, and l is an integer of 0 or more and 8 or less. m is an integer of 1 or more and 3 or less, and n is an integer of 0 or more and 2 or less, provided that m + n is 3. X is a bidentate ligand, and a partial structure IrX is any of structures represented by general formulae [2] and [3]. In formula [2] or [3], R₉ to R₁₉ are each independently selected from an alkyl group and so forth. A ring A is any of structures represented by general formulae [4] to [7]. In formulae [4] to [7], R₂₀ to R₂₉ are each independently selected from a hydrogen atom, an alkyl group, and so forth.

## Description

### Technical Field

The present invention relates to an organic compound and an organic light-emitting device.

### Background Art

An organic light-emitting device (hereinafter, also referred to as an "organic electroluminescent device" or "organic EL device") is an electronic device including a pair of electrodes and an organic compound layer disposed between these electrodes. The injection of electrons and holes from these pairs of electrodes generates excitons in the light-emitting organic compound in the organic compound layer, and when the excitons return to the ground state, the organic light-emitting device emits light.

Recent progress in organic light-emitting devices has been remarkable, and their features include low driving voltage, various emission wavelengths, fast response time, and a contribution to enabling light-emitting apparatuses to be thinner and lighter.

Examples of high-efficiency light-emitting devices include devices containing high-efficiency materials, such as phosphorescent materials.

Patent Literature 1 describes the following compound A-1. Patent Literature 2 describes the following compound A-2. Patent Literature 3 describes the use of the following compound A-3 as a ligand for an iridium complex.

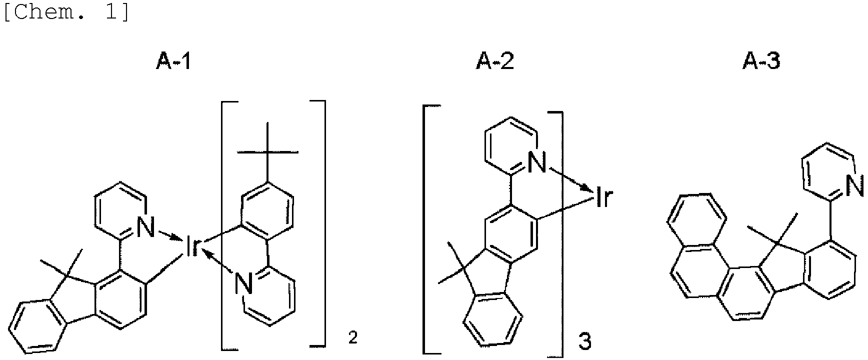

### Citation List

### Patent Literature

PTL 1: Chinese Patent Application Publication No. 111690016
PTL 2: Japanese Patent Laid-Open No. 2002-332291
PTL 3: Japanese Patent Laid-Open No. 2019-163239

### Summary of Invention

### Technical Problem

When compound A-1 described in Patent Literature 1 or compound A-2 described in Patent Literature 2 is used in a light-emitting layer in an organic light-emitting device, there is a problem with luminous efficiency. The iridium complex using the ligand A-3 described in Patent Literature 3 has a problem with sublimability and vapor deposition stability, and thus has a problem with luminous efficiency when used in a light-emitting layer in an organic light-emitting device.

The present invention has been made to solve the above-mentioned problems and aims to provide an organic compound having excellent luminous efficiency when the organic compound is used in an organic light-emitting device, particularly in a light-emitting layer in an organic light-emitting device.

### Solution to Problem

An organic compound of the present invention is characterized by being represented by the following general formula [1].

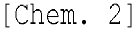

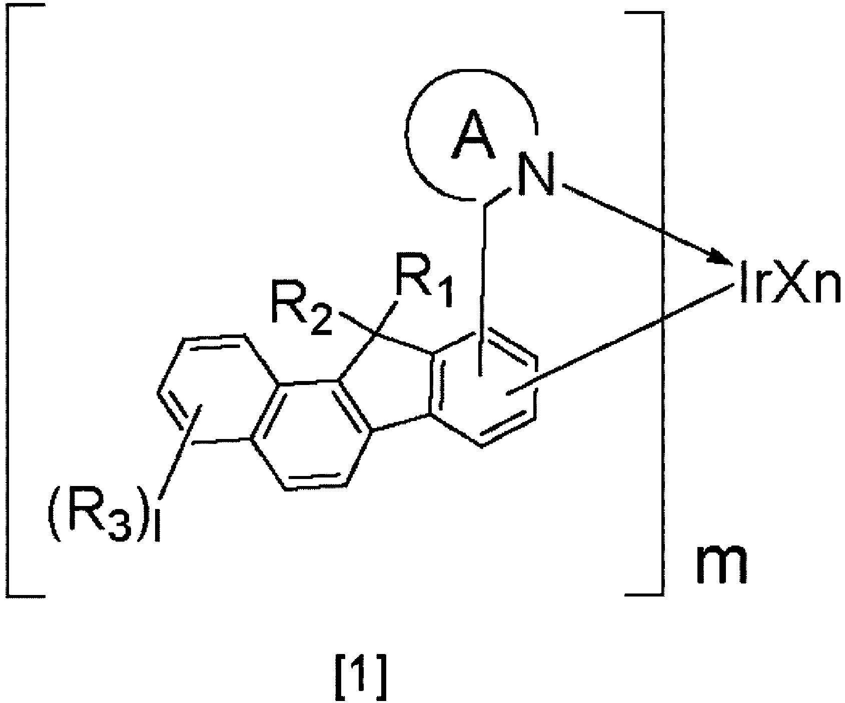

In formula [1], R₁ and R₂ are each independently selected from a hydrogen atom, a deuterium atom, a substituted or unsubstituted alkyl group, a substituted or unsubstituted silyl group, a substituted or unsubstituted aryl group, and a substituted or unsubstituted heterocyclic group.

Each R₃ is independently selected from a deuterium atom, a halogen atom, a cyano group, a substituted or unsubstituted alkyl group, a substituted or unsubstituted alkoxy group, a substituted or unsubstituted silyl group, a substituted or unsubstituted aryl group, and a substituted or unsubstituted heterocyclic group. 1 is an integer of 0 or more and 8 or less.

m is an integer of 1 or more and 3 or less, and n is an integer of 0 or more and 2 or less, provided that m + n is 3.

X is a bidentate ligand, and a partial structure IrX is any of structures represented by the following general formulae [2] and [3].

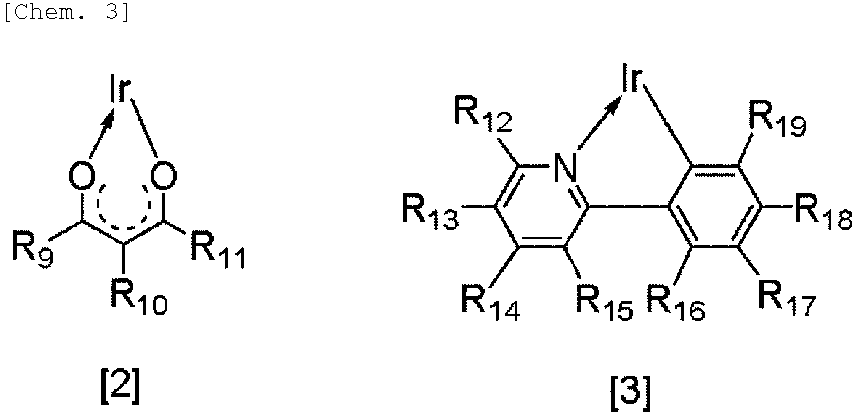

In formula [2] or [3], R₉ to R₁₉ are each independently selected from a hydrogen atom, a deuterium atom, a halogen atom, a cyano group, a substituted or unsubstituted alkyl group, a substituted or unsubstituted alkoxy group, a substituted or unsubstituted silyl group, a substituted or unsubstituted aryl group, and a substituted or unsubstituted heterocyclic group. Adjacent groups of R₁₆ to R₁₉ may be taken together to form a ring.

A ring A is any of structures represented by the following general formulae [4] to [7].

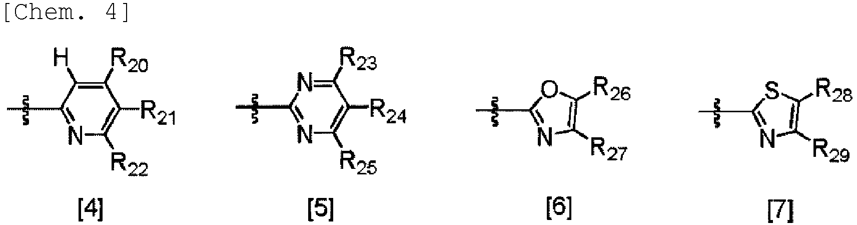

In formulae [4] to [7], R₂₀ to R₂₉ are each independently selected from a hydrogen atom, a deuterium atom, a halogen atom, a cyano group, a substituted or unsubstituted alkyl group, a substituted or unsubstituted alkoxy group, a substituted or unsubstituted silyl group, a substituted or unsubstituted aryl group, and a substituted or unsubstituted heterocyclic group.

### Advantageous Effects of Invention

The present invention provides an organic compound having excellent luminous efficiency when the organic compound is used in an organic light-emitting device, particularly in a light-emitting layer in an organic light-emitting device.

### Brief Description of Drawings

[Fig. 1] Fig. 1 illustrates the characteristics of a compound represented by general formula [11].
[Fig. 2A] Fig. 2A is a schematic cross-sectional view of an example of a pixel of a display apparatus according to an embodiment of the present invention
[Fig. 2B] Fig. 2B is a schematic cross-sectional view of an example of a display apparatus including organic light-emitting devices according to an embodiment of the present invention.
[Fig. 3] Fig. 3 is a schematic view of an example of a display apparatus according to an embodiment of the present invention.
[Fig. 4A] Fig. 4A is a schematic view of an example of an image pickup apparatus according to an embodiment of the present invention.
[Fig. 4B] Fig. 4B is a schematic view of an example of an electronic apparatus according to an embodiment of the present invention.
[Fig. 5A] Fig. 5A is a schematic view of an example of a display apparatus according to an embodiment of the present invention.
[Fig. 5B] Fig. 5B is a schematic view of an example of a foldable display apparatus.
[Fig. 6A] Fig. 6A is a schematic view of an example of a lighting apparatus according to an embodiment of the present invention.
[Fig. 6B] Fig. 6B is a schematic view of an example of a moving object including an automotive lighting unit according to an embodiment of the present invention.
[Fig. 7A] Fig. 7A is a schematic view illustrating an example of a wearable device according to an embodiment of the present invention.
[Fig. 7B] Fig. 7B is a schematic view of another example of a wearable device according to an embodiment of the present invention.
[Fig. 8A] Fig. 8A is a schematic view of an example of an image-forming apparatus according to an embodiment of the present invention.
[Fig. 8B] Fig. 8B is a schematic view of an example of an exposure light source of an image-forming apparatus according to an embodiment of the present invention.
[Fig. 8C] Fig. 8C is a schematic view of an example of an exposure light source of an image-forming apparatus according to an embodiment of the present invention. Description of Embodiments

### <<Organic Compound>>

An organic compound of the present invention is represented by the following general formula [1].

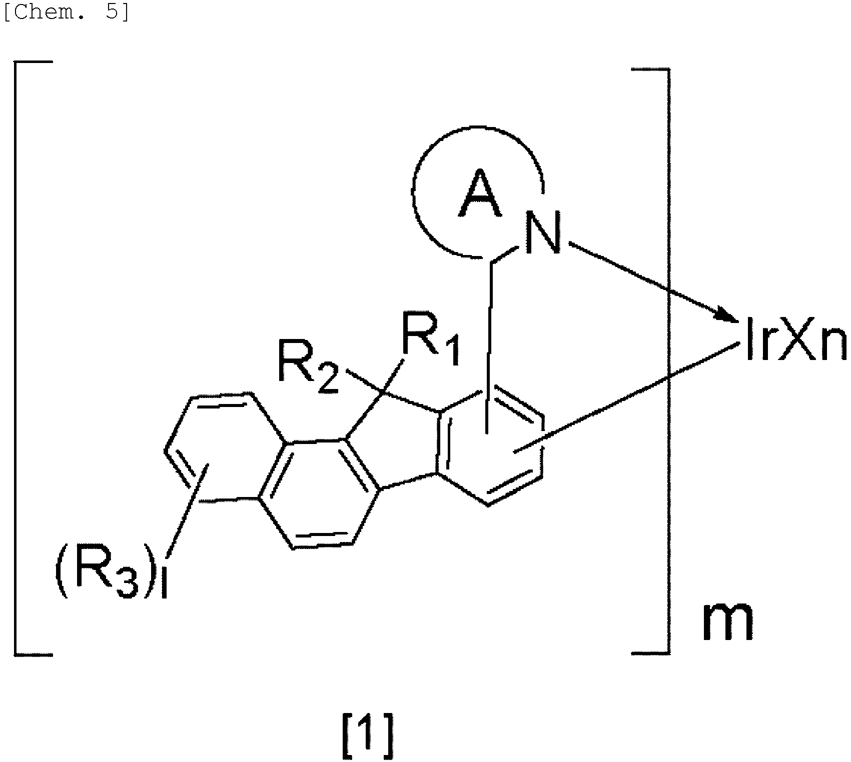

### <R₁ and R₂>

In formula [1], R₁ and R₂ are each independently selected from a hydrogen atom, a deuterium atom, a substituted or unsubstituted alkyl group, a substituted or unsubstituted silyl group, a substituted or unsubstituted aryl group, and a substituted or unsubstituted heterocyclic group. Each of R₁ and R₂ is preferably a substituted or unsubstituted alkyl group.

Examples of the alkyl group include, but are not limited to, a methyl group, an ethyl group, a n-propyl group, an isopropyl group, a n-butyl group, a tert-butyl group, a sec-butyl group, an octyl group, a cyclohexyl group, a tert-pentyl group, a 3-methylpentan-3-yl group, a 1-adamantyl group, and a 2-adamantyl group. As the alkyl group, an alkyl group having 1 or more and 10 or less carbon atoms is preferred.

Examples of the silyl group include, but are not limited to, a trimethylsilyl group and a triphenylsilyl group.

Examples of the aryl group include, but are not limited to, a phenyl group, a naphthyl group, an indenyl group, a biphenyl group, a terphenyl group, a fluorenyl group, a phenanthryl group, a triphenylenyl group, a pyrenyl group, an anthranyl group, a perylenyl group, a chrysenyl group, and a fluoranthenyl group. As the aryl group, an aryl group having 6 or more and 30 or less carbon atoms is preferred.

Examples of the heterocyclic group include, but are not limited to, a pyridyl group, a pyrimidyl group, a pyrazyl group, a triazyl group, a benzofuranyl group, a benzothiophenyl group, a dibenzofuranyl group, a dibenzothiophenyl group, an oxazolyl group, an oxadiazolyl group, a thiazolyl group, a thiadiazolyl group, a carbazolyl group, an acridinyl group, a phenanthrolyl group, and a thienyl group. As the heterocyclic group, a heterocyclic group having 3 or more and 27 or less carbon atoms is preferred.

Examples of substituents that may be further contained in the alkyl group, the silyl group, the aryl group, and the heterocyclic group include, but are not limited to, deuterium, alkyl groups, such as a methyl group, an ethyl group, a n-propyl group, an isopropyl group, a n-butyl group, and a tert-butyl group; aralkyl groups, such as a benzyl group; aryl groups, such as a phenyl group and a biphenyl group; halogen atoms, such as fluorine, chlorine, bromine, and iodine; and a thiol group.

### <R3>

Each R₃ is independently selected from a deuterium atom, a halogen atom, a cyano group, a substituted or unsubstituted alkyl group, a substituted or unsubstituted alkoxy group, a substituted or unsubstituted silyl group, a substituted or unsubstituted aryl group, and a substituted or unsubstituted heterocyclic group, and l is an integer of 0 or more and 8 or less. When l is 2 or more, a plurality of R₃ present may be the same or different from each other.

Examples of the halogen atom include, but are not limited to, fluorine, chlorine, bromine, and iodine.

Examples of the alkoxy group include, but are not limited to, a methoxy group, an ethoxy group, an isoprooxy group, and a tert-butoxy group. As the alkoxy group, an alkoxy group having 1 or more and 10 or less carbon atoms is preferred.

Specific examples of the alkyl group, the silyl group, the aryl group, and the heterocyclic group include, but are not limited to, the same as those described for R₁ and R₂. As the alkyl group, an alkyl group having 1 or more and 10 or less carbon atoms is preferred. As the aryl group, an aryl group having 6 or more and 30 or less carbon atoms is preferred. As the heterocyclic group, a heterocyclic group having 3 or more and 27 or less carbon atoms is preferred.

Specific examples of substituents that may further be contained in the alkyl group, the alkoxy group, the silyl group, the aryl group, and the heterocyclic group include, but are not limited to, the same as those described for R₁ and R₂.

### <m and n>

m is an integer of 1 or more and 3 or less, and n is an integer of 0 or more and 2 or less, provided that m + n = 3. When m is 2 or more, a plurality of ligands present may be the same or different from each other. When n is 2, a plurality of X present may be the same or different from each other.

### <X>

X is a bidentate ligand, and a partial structure IrX is any of structures represented by the following general formulae [2] and [3]. Ir is iridium.

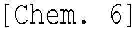

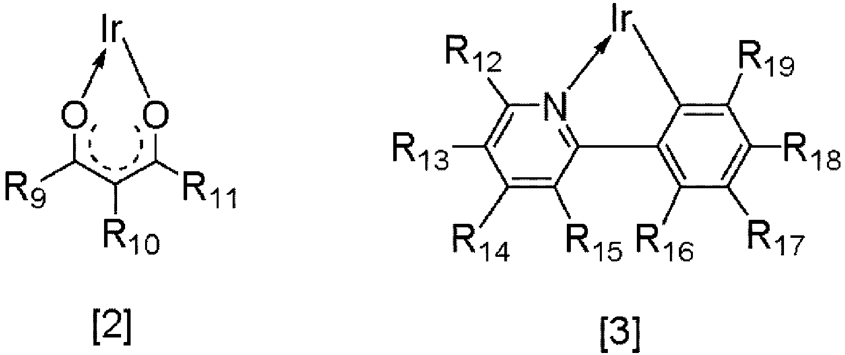

### [R₉ to R₁₉]

In formula [2] or [3], R₉ to R₁₉ are each independently selected from a hydrogen atom, a deuterium atom, a halogen atom, a cyano group, a substituted or unsubstituted alkyl group, a substituted or unsubstituted alkoxy group, a substituted or unsubstituted silyl group, a substituted or unsubstituted aryl group, and a substituted or unsubstituted heterocyclic group.

Specific examples of the halogen atom, the alkyl group, the alkoxy group, the silyl group, the aryl group, and the heterocyclic group that are represented by R₉ to R₁₉ include, but are not limited to, the same as those described for R₃. As the alkyl group, an alkyl group having 1 or more and 10 or less carbon atoms is preferred. As the alkoxy group, an alkoxy group having 1 or more and 10 or less carbon atoms is preferred. As the aryl group, an aryl group having 6 or more and 30 or less carbon atoms is preferred.

As the heterocyclic group, a heterocyclic group having 3 or more and 27 or less carbon atoms is preferred. Specific examples of substituents that may further be contained in the alkyl group, the alkoxy group, the silyl group, the aryl group, and the heterocyclic group include, but are not limited to, the same as those described for R₃.

Adjacent groups of R₁₆ to R₁₉ may be taken together to form a ring. The expression "adjacent groups of R₁₆ to R₁₉ are taken together to form a ring" means that a ring formed by taking R₁₆ and R₁₇, R₁₇ and R₁₈, or R₁₈ and R₁₉ together and the benzene ring to which R₁₆ to R₁₉ are attached form a fused ring. The ring formed by taking adjacent groups of R₁₆ to R₁₉ together may be an aromatic ring.

### <A>

The ring A is any of structures represented by the following general formulae [4] to [7].

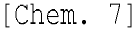

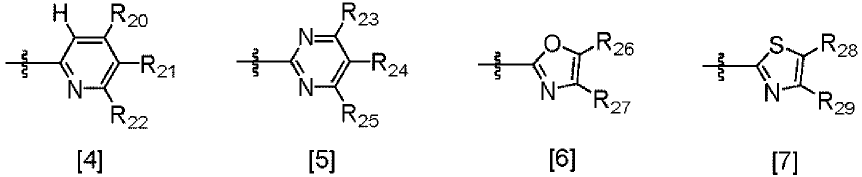

### [R₂₀ to R₂₉]

In formulae [4] to [7], R₂₀ to R₂₉ are each independently selected from a hydrogen atom, a deuterium atom, a halogen atom, a cyano group, a substituted or unsubstituted alkyl group, a substituted or unsubstituted alkoxy group, a substituted or unsubstituted silyl group, a substituted or unsubstituted aryl group, and a substituted or unsubstituted heterocyclic group. At least one of R₂₀ to R₂₉ is preferably a tertiary alkyl group, and the tertiary alkyl group is preferably a tert-butyl group.

Specific examples of the halogen atom, the alkyl group, the alkoxy group, the silyl group, the aryl group, and the heterocyclic group that are represented by R₂₀ to R₂₉ include, but are not limited to, the same as those described for R₃. As the alkyl group, an alkyl group having 1 or more and 10 or less carbon atoms is preferred. As the alkoxy group, an alkoxy group having 1 or more and 10 or less carbon atoms is preferred. As the aryl group, an aryl group having 6 or more and 30 or less carbon atoms is preferred.

As the heterocyclic group, a heterocyclic group having 3 or more and 27 or less carbon atoms is preferred. Specific examples of substituents that may further be contained in the alkyl group, the alkoxy group, the silyl group, the aryl group, and the heterocyclic group include, but are not limited to, the same as those described for R₃.

The organic compound of the present embodiment is preferably represented by the following general formula [10].

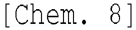

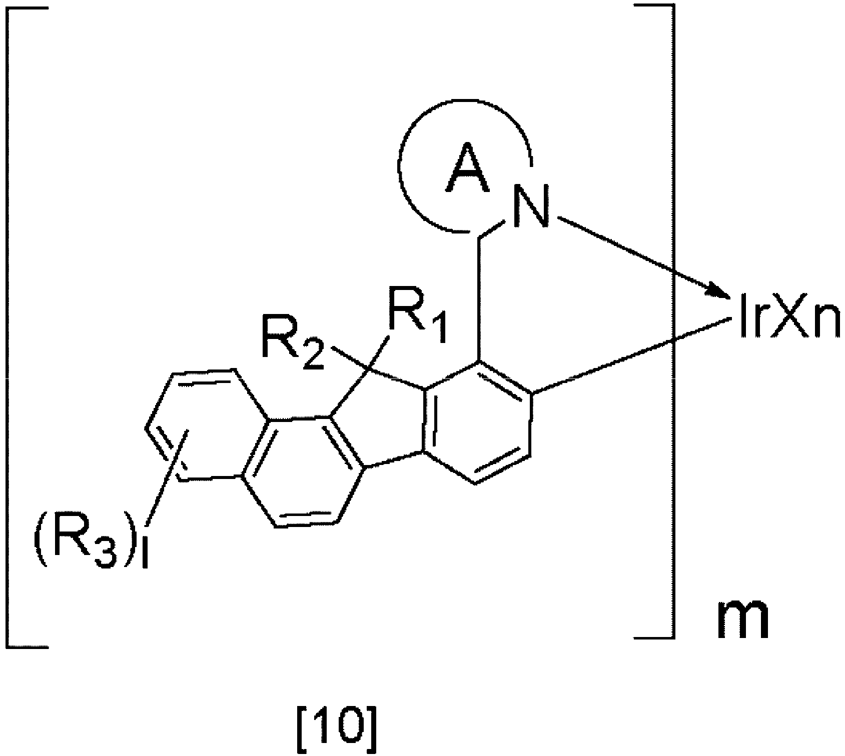

The organic compound of the present embodiment is preferably represented by the following general formula [11].

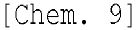

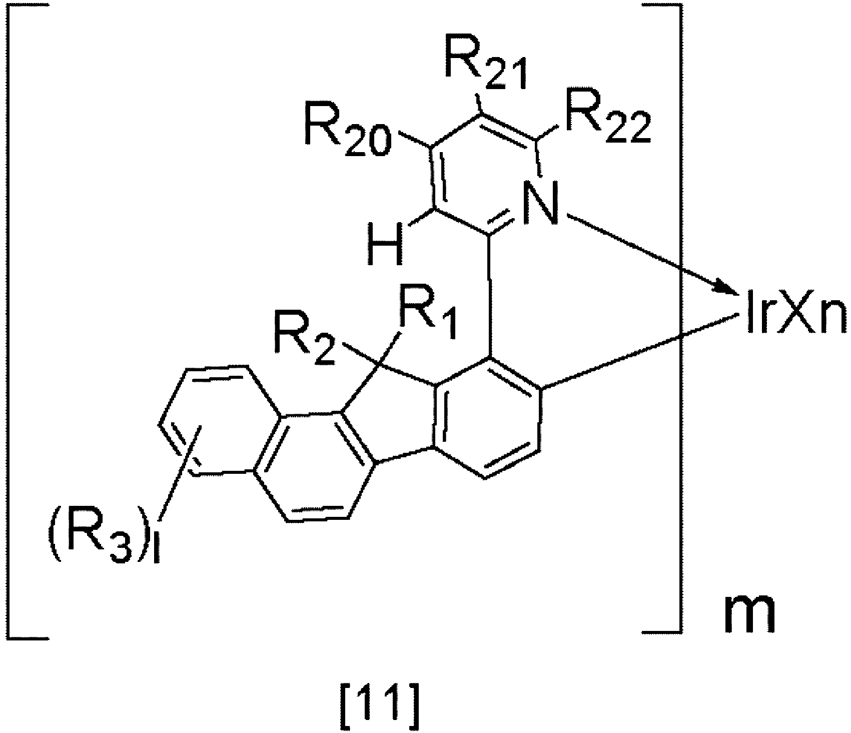

The organic compound of the present embodiment has the features described below.
(1-1) The benzofluorene ring is contained in the ligand, so that the complex has a high degree of orientation and a high photoluminescence quantum yield.
(1-2) The sublimation temperature is low, so that decomposition is less likely to occur during sublimation purification.
(1-3) The benzofluorene ring is contained in the ligand, thereby providing high hole transportability.

These will be described below.

(1-1) The benzofluorene ring is contained in the ligand, so that the complex has a high degree of orientation and a high photoluminescence quantum yield.

The organic compound of the present embodiment has a high photoluminescence quantum yield. In the invention of the organometallic complex, attention was paid to the structure of the ligand of the organometallic complex. Specifically, an attempt has been made to improve the quantum yield by using a benzofluorene skeleton for aromatic rings among aromatic rings and a heterocyclic ring constituting the ligand of the Ir complex.

Table 1 presents the comparison results of the photoluminescence quantum yields of compound 1 (exemplified compound D-1 described below) and comparative compound 1. Regarding the measurement of quantum yields, absolute quantum yields in diluted toluene solutions were measured with an absolute PL quantum yield spectrometer (C9920-02) manufactured by Hamamatsu Photonics K.K. The quantum yield is expressed as a relative value on the assumption that the quantum yield of compound 1 is 1.0.

### [Table 1]

**Table 1**

| Compound | | Photoluminescence quantum yield |
|---|---|---|
| Compound 1 (D-1) | 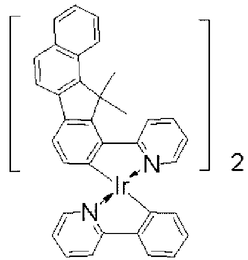 | 1.0 |
| Comparative compound 1 | 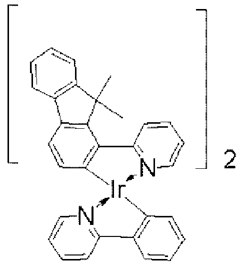 | 0.8 |
| Comparative compound 2 | 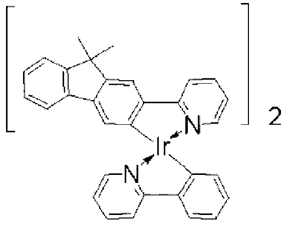 | 0.8 |

Table 1 indicates that compound 1 has a higher quantum yield and better light emission characteristics than comparative compounds 1 and 2. Thus, compound 1 is superior in luminous efficiency to comparative compounds 1 and 2 when used in the light-emitting layer of an organic light-emitting device.

The compound of the present embodiment contains a benzofluorene ring in the ligand. It is considered that the transition dipole moment was increased by the condensation of one more benzene ring with respect to the fluorene ring possessed by the ligand of each of the comparative compounds, thereby improving the photoluminescence quantum yield.

(1-2) The sublimation temperature is low, so that decomposition is less likely to occur during sublimation purification.

As described in (1-1), the compound of the present embodiment is characterized by a high quantum yield because of the presence of the benzofluorene ring in the ligand. The inventors have also studied a ligand containing a ring in which a benzene ring is further fused, such as a naphthofluorene ring. However, it was found that a compound having a naphthofluorene ring, in which a benzene ring is further fused with a benzofluorene ring, in a ligand was decomposed during sublimation purification as described below.

Table 2 presents the sublimation temperature at the time of sublimation purification of each material and the presence or absence of decomposition product peaks by HPLC for materials obtained after sublimation purification. The degree of vacuum during the sublimation purification is in the range of 1 × 10⁻³ to 1 × 10⁻² Pa.

### [Table 2]

**Table 2**

| Compound | | Sublimation temperature | Decomposition peak after sublimation purification |
|---|---|---|---|
| Compound 1 (D-1) | 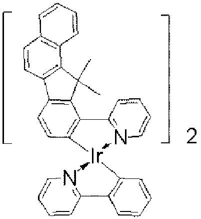 | 390°C | No |
| Comparative compound 3 | 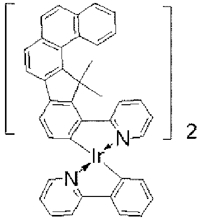 | 450°C | Yes |

The results indicate that comparative compound 3 has a high sublimation temperature and is decomposed by sublimation purification. The significantly increased sublimation temperature is seemingly attributed to an increase in molecular weight due to further condensation of the benzene ring and an increase in stackability between complex molecules due to the increased planarity of the ligand.

In contrast, regarding compound 1, it was found that the stackability of complex molecules was reduced to some extent to result in a low sublimation temperature. For this reason, decomposition is less likely to occur when sublimation purification is performed. The purity can be increased by sublimation purification; hence, the luminous efficiency and the driving durability of the organic light-emitting device can be increased by using compound 1. Therefore, compound 1 is superior in luminous efficiency to comparative compound 3 when used in the light-emitting layer of an organic light-emitting device.

(1-3) The benzofluorene ring is contained in the ligand, thereby providing high hole transportability.

The organic compound of the present embodiment contains the benzofluorene ring in its ligand and thus has high hole transportability. This seems to be due to a structure in which benzofluorene rings of the ligands easily overlap each other and hole hopping easily occurs between the ligands.

Furthermore, the compound of the present embodiment preferably has the following features.

(1-4) In the case of the compound represented by general formula [11], the half-width of the emission spectrum is narrow, and light with high color purity is emitted.

(1-5) At least one of R₃ and R₂₀ to R₂₉ is a tertiary alkyl group, thereby resulting in improved sublimability.

These will be described below.

(1-4) In the case of the compound represented by general formula [11], the half-width of the emission spectrum is narrow, and light with high color purity is emitted.

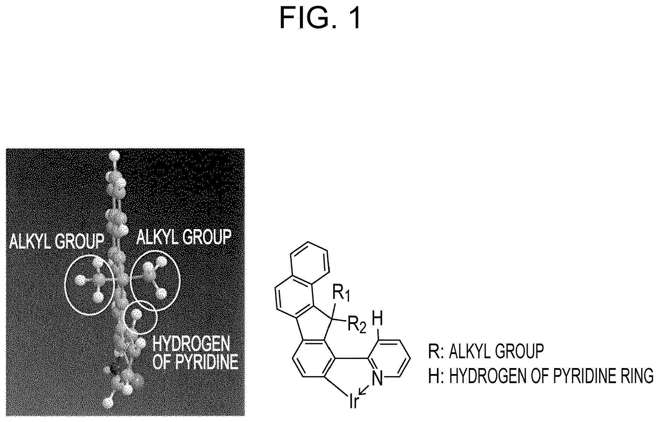

In the compound represented by general formula [11], the ring A has the structure represented by formula [4] and is attached to the 10-position of the benzofluorene ring. Thus, as illustrated in Fig. 1, R₁ and R₂, preferably alkyl groups, located at the 11-position of the benzofluorene ring are arranged so as to sandwich the hydrogen of the pyridine ring. Because of the repulsion of the hydrogen of the pyridine ring with R₁ and R₂, especially with alkyl groups, of the benzofluorene ring on both sides, the dihedral angle between the pyridine ring and the benzofluorene ring is fixed, the rotational energy of the two rings is very high, and the rotation of the bond between the pyridine ring and the benzofluorene ring is inhibited. Thus, in the emission spectrum, the vibration mode is reduced by the rotation control to reduce the half-width of the emission spectrum, thereby providing high color purity.

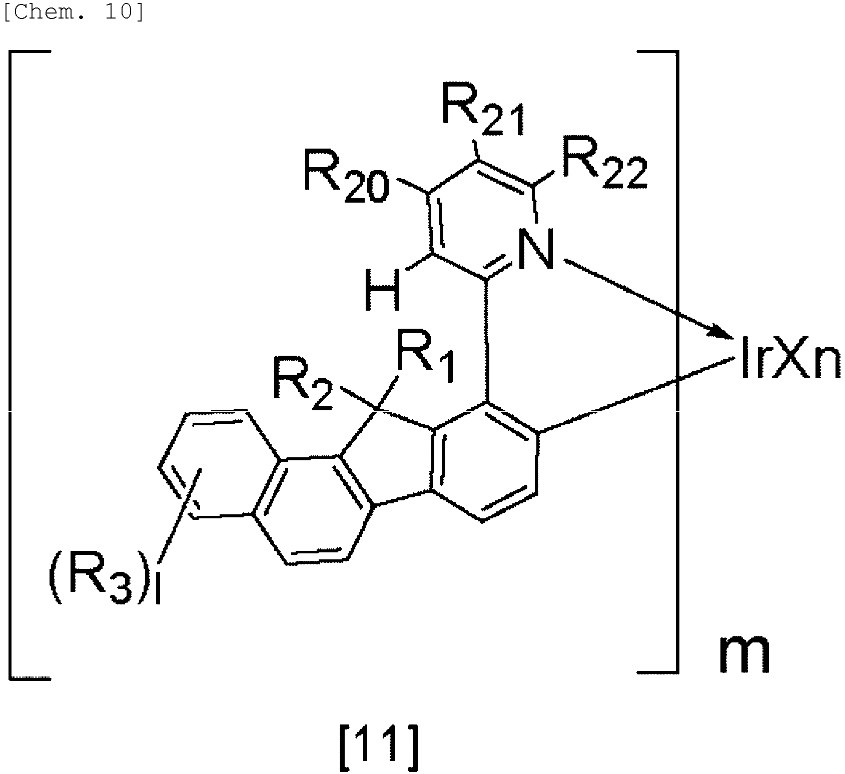

(1-5) At least one of R₃ and R₂₀ to R₂₉ is a tertiary alkyl group, thereby resulting in improved sublimability.

The organic compound of the present embodiment contains the benzofluorene ring in its ligand and thus has the above features. Meanwhile, since the complex has a fused polycyclic moiety, the complex has a high molecular weight and thus may have inferior sublimability. Specifically, the temperature during the sublimation purification may be high. The complex may be partially decomposed after the sublimation purification. For this reason, at least one of R₃ and R₂₀ to R₂₉ is preferably a tertiary alkyl group. This inhibits molecular stacking between the complex molecules, thereby reducing the sublimation temperature. When the number of carbon atoms of the tertiary alkyl group is four or more, the complex molecules provide a large mutual exclusion effect and are highly effective in inhibiting molecular stacking. The presence of the tertiary alkyl group can reduce the temperature-induced radical cleavage of hydrogen located at the benzyl position in the case of a high temperature load.

Table 3 presents the bond dissociation energies of carbon-hydrogen bonds described in ACC. Chem. Res. 36, 255-263 (2003).

### [Table 3]

**Table 3**

| | Bond | Bond dissociation energy (kcal/mol) |
|---|---|---|
| Methyl group | 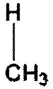 | 105 |
| Ethyl group | 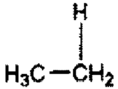 | 101 |
| Phenyl group | 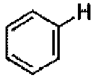 | 113 |
| Benzyl group | 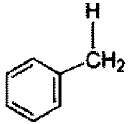 | 90 |

A larger value of the bond dissociation energy indicates a stronger bond, and a smaller value thereof indicates a weaker bond. That is, it can be seen that the carbon-hydrogen bond located at the benzyl position is a weak bond. This is because when a hydrogen atom located at the benzyl position is eliminated to generate a radical, the radical is stabilized owing to the π-electron resonance with the neighboring benzene ring. Thus, the carbon-hydrogen bond located at the benzyl position is a weak bond. That is, when a structure such as a benzyl group is not contained in the molecular structure, the compound is one in which a carbon-hydrogen bond is not easily cleaved, which is preferred.

The organic compound of the present embodiment contains the benzofluorene ring in its ligand and thus has high hole transportability. This seems to be due to a structure in which benzofluorene rings of the ligands easily overlap each other and hole hopping easily occurs between the ligands. Therefore, in order not to reduce the overlap between the benzofluorene rings, on the ring A side, that is, at least one of R₂₀ to R₂₉ is more preferably a tertiary alkyl group.

### <Specific Examples>

Specific examples of the organic compound of the present embodiment are illustrated below, but of course, the organic compound is not limited thereto.

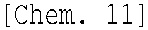

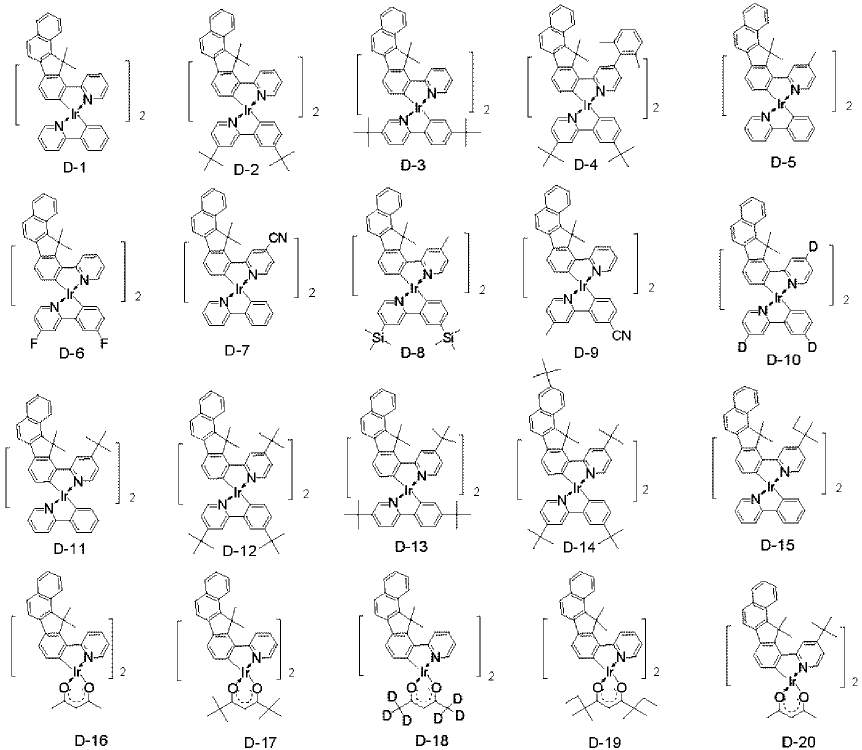

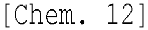

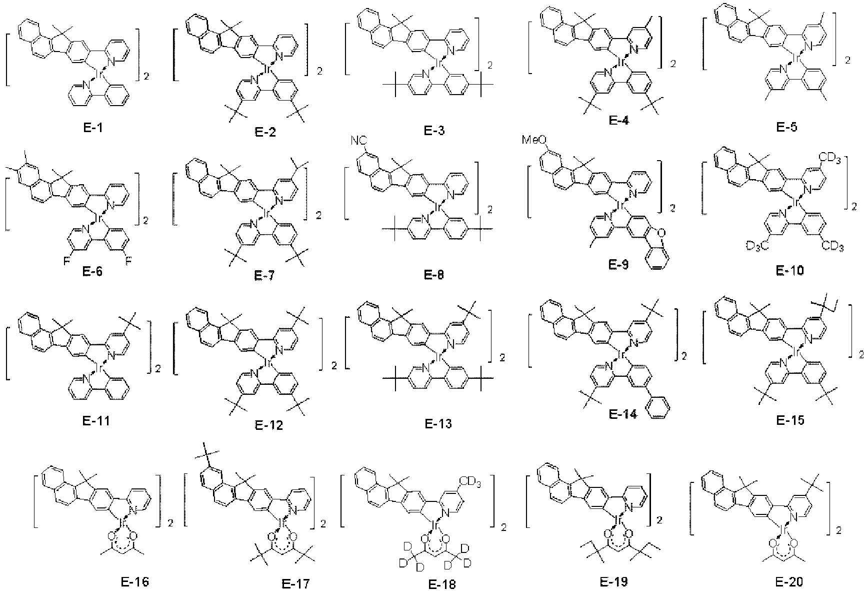

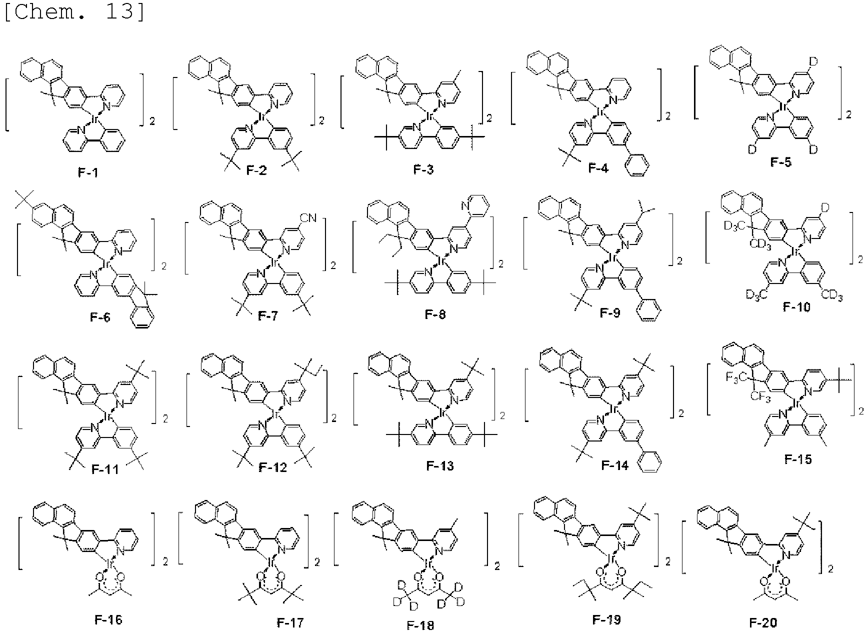

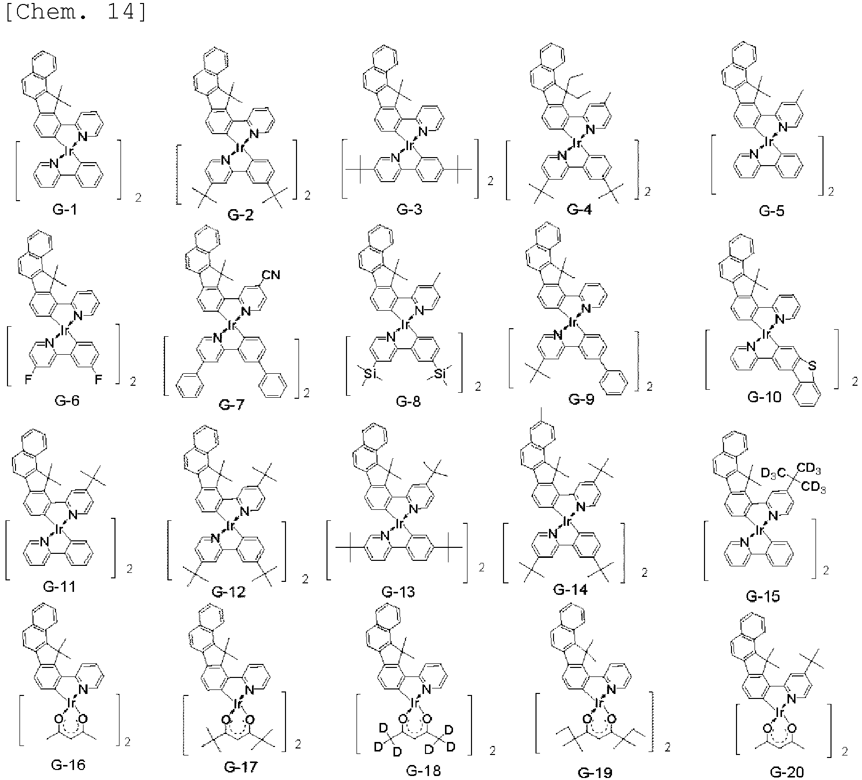

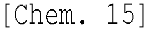

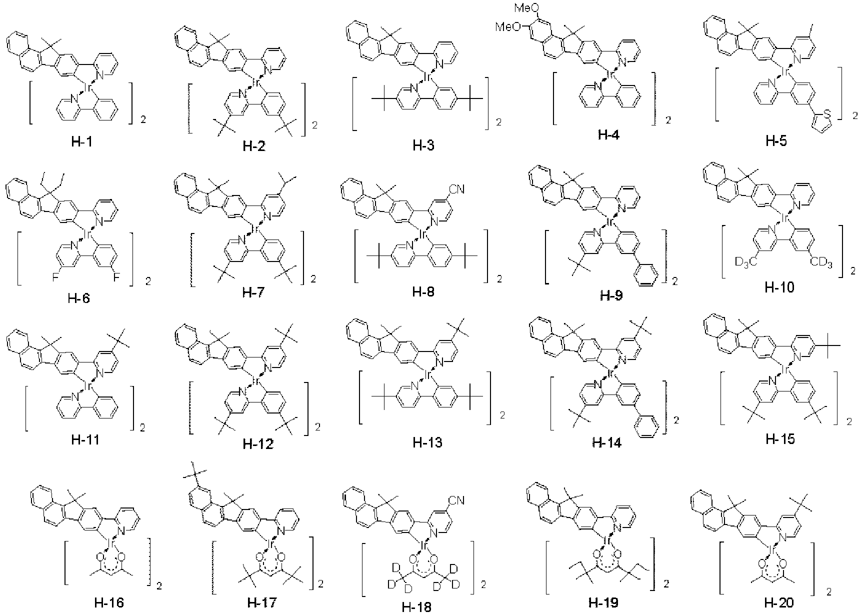

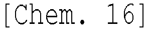

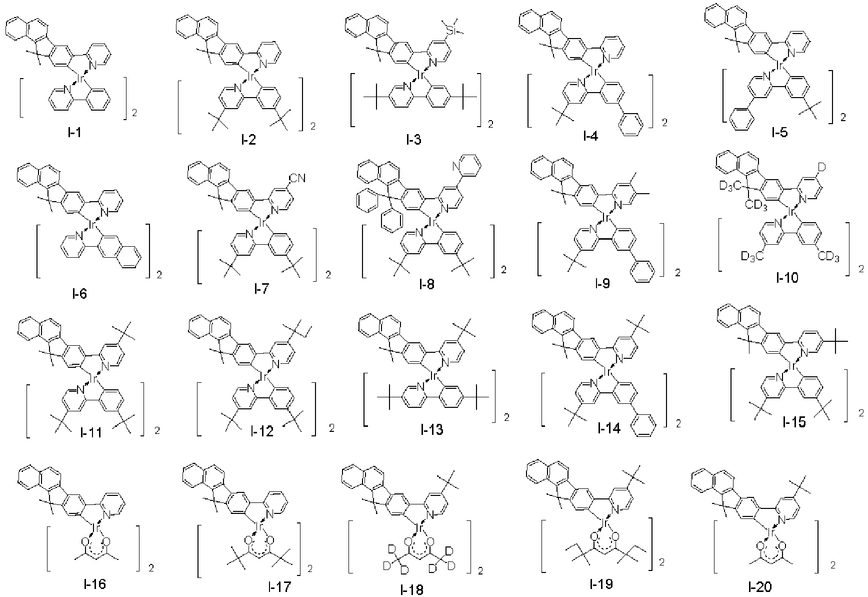

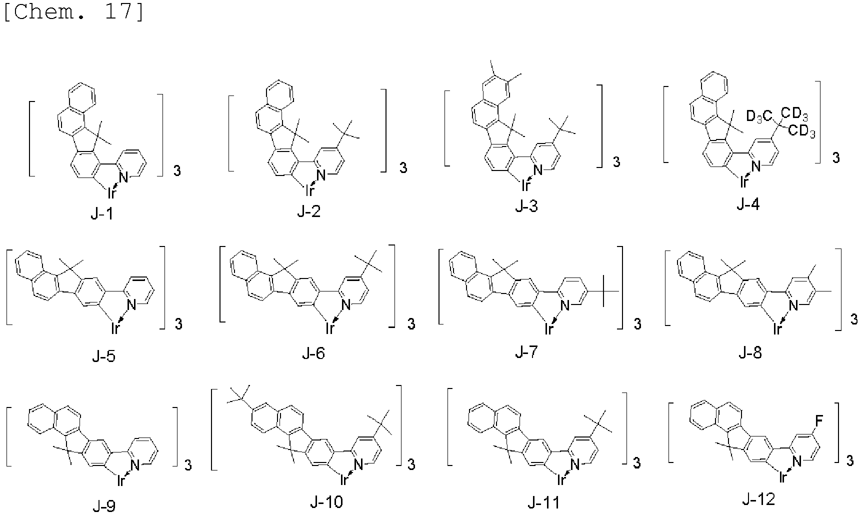

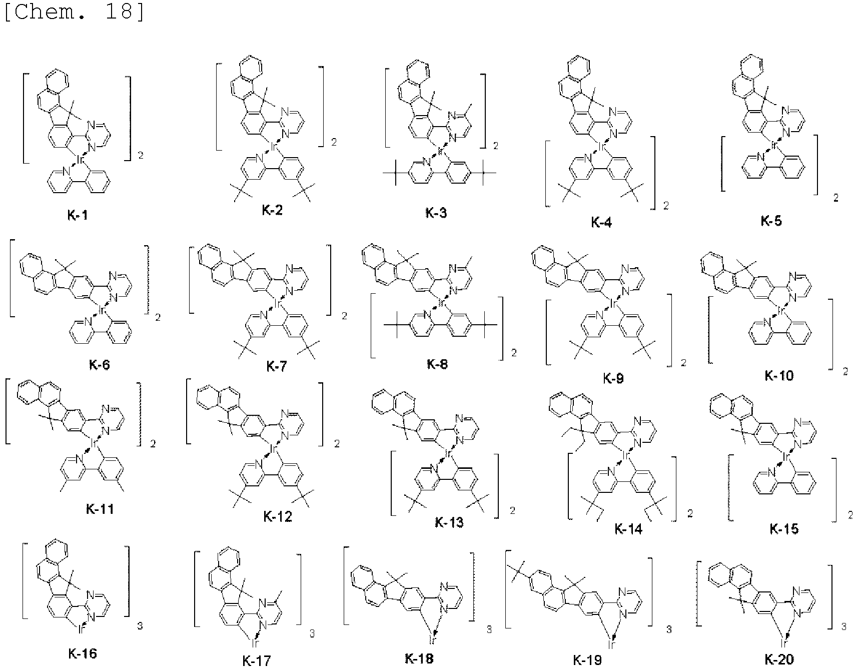

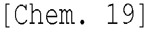

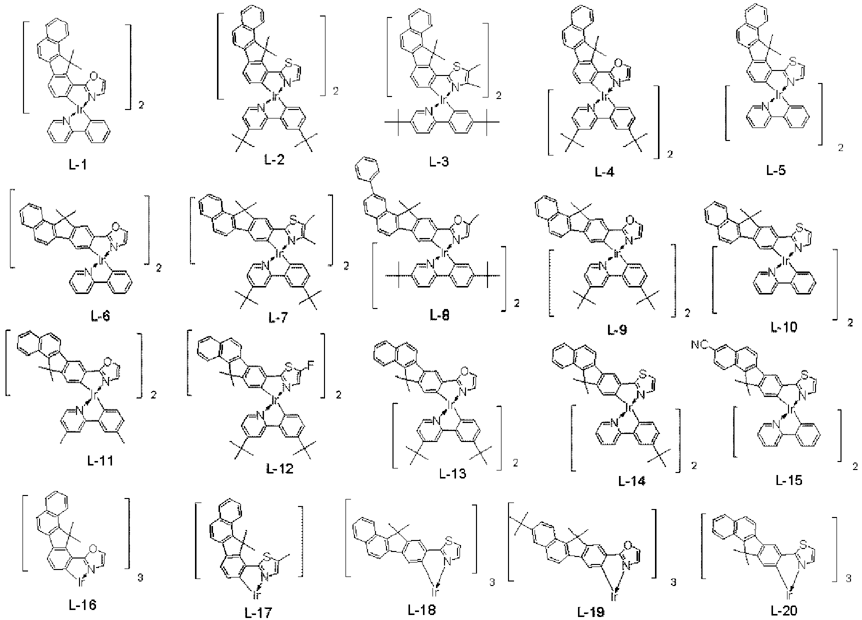

Exemplified compounds belonging to group D are each a compound having two ligands, each ligand containing a benzofluorene ring and a pyridine ring attached to the 10-position of the benzofluorene ring. The compound has two highly planar benzofluorene rings and thus has high hole mobility and a high degree of orientation, thereby improving the light extraction of the light-emitting device. In addition, the half-width of the emission spectrum is narrow as described in (1-4).

Exemplified compounds belonging to group E are each a compound having two ligands, each ligand containing a benzofluorene ring and a pyridine ring attached to the 9-position of the benzofluorene ring. The compound has two highly planar benzofluorene rings and thus has high hole mobility and a high degree of orientation, thereby improving the light extraction of the light-emitting device. In addition, the compound is characterized by having a longer emission wavelength than a compound having ligands, each ligand containing a benzofluorene ring and a pyridine ring attached to the 10- or 8-position of the benzofluorene ring. The compound has a broader emission spectrum than a compound having ligands, each ligand containing a benzofluorene ring and a pyridine ring attached to the 10-position of the benzofluorene ring, and thus can be used as a yellow-green or yellow light-emitting dopant in a two-color white light-emitting device.

Exemplified compounds belonging to group F are each a compound having two ligands, each ligand containing a benzofluorene ring and a pyridine ring attached to the 8-position of the benzofluorene ring. The compound has two highly planar benzofluorene rings and thus has high hole mobility and a high degree of orientation, thereby improving the light extraction of the light-emitting device. The compound has a broader emission spectrum than a compound having ligands, each ligand containing a benzofluorene ring and a pyridine ring attached to the 10-position of the benzofluorene ring, and thus can be used as a yellow-green or yellow light-emitting dopant in a two-color white light-emitting device.

Exemplified compounds belonging to group G are each a compound having one ligand in which a pyridine ring is attached to the 10-position of a benzofluorene ring. The complex has a low molecular weight and thus has a low sublimation temperature and a low vapor deposition temperature. In addition, the half-width of the emission spectrum is narrow as described in (1-4).

Exemplified compounds belonging to group H are each a compound having one ligand in which a pyridine ring is attached to the 9-position of a benzofluorene ring. The complex has a low molecular weight and thus has a low sublimation temperature and a low vapor deposition temperature. In addition, the compound is characterized by having a longer emission wavelength than a compound having a ligand in which a pyridine ring is attached to the 10- or 8-position of a benzofluorene ring. The compound has a broader emission spectrum than a compound having a ligand in which a pyridine ring is attached to the 10-position of a benzofluorene ring, and thus can be used as a yellow-green or yellow light-emitting dopant in a two-color white light-emitting device.

Exemplified compounds belonging to group I are each a compound having one ligand in which a pyridine ring is attached to the 8-position of a benzofluorene ring. The compound has one highly planar benzofluorene ring and thus has high hole mobility and a high degree of orientation, thereby improving the light extraction of the light-emitting device. The compound has a broader emission spectrum than a compound having a ligand in which a pyridine ring is attached to the 10-position of a benzofluorene ring, and thus can be used as a yellow-green or yellow light-emitting dopant in a two-color white light-emitting device.

Exemplified compounds belonging to group J are each a compound having three ligands, each ligand containing a benzofluorene ring and a pyridine ring attached to the benzofluorene ring. The compound has three highly planar benzofluorene rings and thus has high hole mobility and a high degree of orientation, thereby improving the light extraction of the light-emitting device.

The exemplified compounds belonging to groups K and L are each a compound having a ligand in which a pyrimidine ring, an oxazole ring, or a thiazole ring is attached to a benzofluorene ring. The compound containing a pyrimidine ring with a strong electron-withdrawing ability has a low lowest unoccupied molecular orbital (LUMO) level (far from the vacuum level). Thus, when the compound is used as a light-emitting dopant in a light-emitting layer, the compound is characterized by easily trapping electrons and having a good balance between injection and transport of electrons and holes in the light-emitting layer.

### <<Organic Light-Emitting Device>>

An organic light-emitting device of the present embodiment includes at least a first electrode, a second electrode, and an organic compound layer disposed between these electrodes. The first electrode and the second electrode may be an anode and a cathode, respectively. In the organic light-emitting device of the present embodiment, the organic compound layer may be formed of a single layer or a laminate including multiple layers, as long as it includes a light-emitting layer. When the organic compound layer is formed of a laminate including multiple layers, the organic compound layer may include, in addition to the light-emitting layer, a hole injection layer, a hole transport layer, an electron-blocking layer, a hole/exciton-blocking layer, an electron transport layer, and an electron injection layer, for example. The light-emitting layer may be formed of a single layer or a laminate including multiple layers.

In the organic light-emitting device of the embodiment, the organic compound according to the present embodiment is contained in at least one layer of the organic compound layer. Specifically, the organic compound according to the present embodiment is contained in any of the above-described light-emitting layer, the hole injection layer, the hole transport layer, the electron-blocking layer, the light-emitting layer, the hole/exciton-blocking layer, the electron transport layer, the electron injection layer, and so forth. The organic compound according to the present embodiment is preferably contained in the light-emitting layer.

In the organic light-emitting device of the present embodiment, when the organic compound according to the present embodiment is contained in the light-emitting layer, the light-emitting layer may be made of only the organic compound according to the present embodiment or may be made of the organic compound according to the present embodiment and another compound. When the light-emitting layer is a layer made of the organic compound according to the present embodiment and another compound, the organic compound according to the present embodiment may be used as a first compound (hereinafter, also referred to as a "host" or a "host material") in the light-emitting layer, or may be used as a second compound (hereinafter, also referred to as a "guest (dopant)" or a "guest (dopant) material"). In addition, the organic compound may be used as a third compound (hereinafter, also referred to as an "assist" or an "assist material") that can be contained in the light-emitting layer.

The term "host" used here refers to a compound having the highest proportion by mass in compounds contained in the light-emitting layer. The term "guest" refers to a compound that has a lower proportion by mass than the host in the compounds contained in the light-emitting layer and that is responsible for main light emission. The term "assist material" refers to a compound that has a lower proportion by mass than the host in the compounds contained in the light-emitting layer and that has the function of assisting the injection and transport of electron and hole carriers.

The concentration of the guest in the organic light-emitting device according to the present embodiment is preferably 0.01% or more by mass and 30% or less by mass, more preferably 2% or more by mass and 20% or less by mass, based on the entire light-emitting layer.

The concentration of the assist material in the organic light-emitting device according to the present embodiment is preferably 0.1% or more by mass and 45% or less by mass, more preferably 5% or more by mass and 40% or less by mass, based on the entire light-emitting layer.

The inventors have conducted various studies and have found that when the organic compound according to the present embodiment is used as a host, a guest, or an assist material in a light-emitting layer, particularly as a guest in a light-emitting layer, a device that exhibits light output with high efficiency and high luminance and that is extremely durable can be provided. It has also been found that when the compound is used as an assist material in a light-emitting layer, a device that exhibits light output with high efficiency and high luminance and that is extremely durable can be provided. The light-emitting layer may be formed of a single layer or multiple layers, and can contain multiple light-emitting materials. The term "multiple layers" may include a state in which a light-emitting layer and another light-emitting layer are stacked or in which an intermediate layer is stacked between multiple light-emitting layers. Tandem or stacked devices are also acceptable. In these cases, the emission color of the organic light-emitting device is not limited to a single color. More specifically, the emission color may be white or an intermediate color.

Regarding a film-forming method, film is formed by vapor deposition or a coating method. The details thereof will be described in examples below.

The organic compound according to the present embodiment can be used as a component material of an organic compound layer other than the light-emitting layer included in the organic light-emitting device of the present embodiment. Specifically, the organic compound may be used as a component material for the electron transport layer, the electron injection layer, the hole transport layer, the hole injection layer, the hole-blocking layer, and so forth.

When the compound represented by general formula [1] is contained in the light-emitting layer, the following features are provided.

(2-1) When the compound represented by general formula [1] is contained as a guest material in the light-emitting layer, the interaction with the host material is strong, so that energy transfer occurs easily.

(2-2) The effect of (2-1) promotes the hole hopping transport between the guest and a host and thus improves the hole transportability in the light-emitting layer.

These will be described below.

(2-1) When the compound represented by general formula [1] is contained as a guest material in the light-emitting layer, the interaction with the host material is strong, so that energy transfer occurs easily.

The compound represented by general formula [1] contains, in its ligand, a benzofluorene ring, which is a fused polycyclic ring composed of four hydrocarbon rings. The host material is preferably a hydrocarbon compound, more preferably a fused polycyclic compound. Since the compound represented by general formula [1] has a fused-ring structure with low polarity and aromaticity in the ligand, a hydrocarbon group, preferably a fused polycyclic group, is also introduced into the host. This facilitates the ππ interaction between the host and the ligand of the guest, thereby facilitating energy transfer from the host.

It is known that in the triplet energy used in phosphorescent devices, energy transfer occurs by the Dexter mechanism. In the Dexter mechanism, energy transfer occurs through contact between molecules. Specifically, a reduction in the intermolecular distance between the host material and the guest material results in efficient energy transfer from the host material to the guest material. The compound represented by general formula [1] has the fused-ring structure with low polarity and aromaticity in the ligand. Thus, a hydrocarbon, preferably a hydrocarbon-based fused-ring structure, is introduced into the host as well, so that ππ interaction between the host and the ligand of the guest occurs easily, thereby facilitating energy transfer from the host.

Due to the above-described effect, the triplet excitons generated in the host material are rapidly consumed for light emission, thus resulting in an organic light-emitting device having high luminous efficiency. It is also possible to reduce the deterioration of the material due to a high-energy triplet excited state caused by further excitation of triplet excitons that are not used for light emission. Thus, the organic light-emitting device has good driving durability characteristics.

(2-2) The effect of (2-1) promotes the hole hopping transport between the guest and a host and thus improves the hole transportability in the light-emitting layer.

The iridium complex represented by general formula [1] contains the benzofluorene ring in the ligand and thus has a lower highest occupied molecular orbital (HOMO) level (closer to the vacuum level) than the host material. Holes injected from the hole transport layer are transported by the host material. These holes are transported while repeatedly trapped and de-trapped between the iridium complex (guest) and the host. In this case, similar skeletons can be used for the host material and the iridium complex. In that case, the overlap between the fused rings of the host and the iridium complex is strong, thus resulting in efficient hole transfer between the iridium complex and the host material. This inhibits a voltage rise at the light-emitting layer and provides an organic light-emitting device operable at a low voltage with good driving durability characteristics.

Moreover, the organic light-emitting device of the present embodiment preferably has the following features. (2-3) Preferably, the light-emitting layer contains an assist material, and the LUMO level of the assist material is lower (farther from the vacuum level) than the LUMO level of the host material. This confines both electron and hole carriers in the light-emitting layer, thus providing a highly efficient device.

(2-4) The effect of (2-3) reduces the injection of carriers into an adjacent transport layer through the light-emitting layer to reduce the deterioration of the transport layer, thereby providing a highly durable device.

These will be described below.

(2-3) Preferably, the light-emitting layer contains an assist material, and the LUMO level of the assist material is lower (farther from the vacuum level) than the LUMO level of the host material. This confines both electron and hole carriers in the light-emitting layer, thus providing a highly efficient device.

The iridium complex of the present embodiment promotes the injection of holes into the light-emitting layer. Thus, the efficiency is preferably increased by injecting electrons and holes into the light-emitting layer in a well-balanced manner. The injection of electrons into the light-emitting layer is preferably promoted. A hydrocarbon compound suitable as a host material tends to have a wide band gap. The host material has a high LUMO level (close to the vacuum level). It may be difficult to inject electrons from the electron transport layer and the hole-blocking layer. To facilitate the injection of electrons into the light-emitting layer, preferably, an assist material is further contained. The LUMO level of the assist material is preferably lower than the LUMO level of the host material. This improves the injectability of both holes and electrons into the light-emitting layer to maintain a good carrier balance in the light-emitting layer, thus providing a highly efficient light-emitting device.

(2-4) The effect of (2-3) reduces the injection of carriers into an adjacent transport layer through the light-emitting layer to reduce the deterioration of the transport layer, thereby providing a highly durable device.

In the device of the present embodiment, as described above, the iridium complex of the present embodiment has the effects of promoting the hole injectability in the light-emitting layer and confining holes in the light-emitting layer by hole trapping. This reduces the injection of holes from the light-emitting layer into the hole-blocking layer and the electron transport layer to reduce the deterioration of the hole-blocking layer and the electron transport layer due to holes.

The assist material having a lower LUMO level than the host material has the effect of promoting the electron injectability and confining electrons in the light-emitting layer by electron trapping. This reduces the injection of electrons from the light-emitting layer to an electron-blocking layer and the hole transport layer to reduce the deterioration of the electron-blocking layer and the hole transport layer by electrons.

### <Host Material>

The host material is preferably a hydrocarbon compound. The host material preferably has a higher lowest triplet excitation energy (T₁) level than the iridium complex represented by general formula [1]. Specifically, the iridium complex of the present embodiment has a light emission range of 500 nm to 600 nm. Thus, the T₁ of the host material is preferably 2.2 eV or more, more preferably 2.5 eV or more. As described above, in order to enhance the interaction with the benzofluorene ring of the ligand of the iridium complex, the host material is preferably a fused polycyclic compound. Specific examples of a fused polycyclic group having a T₁ of 2.2 eV or more include fluoranthene, benzo[e]pyrene, benzo[g]chrysene, benzo[c]chrysene, coronene, benzofluorene, chrysene, picene, naphthalene, phenanthrene, triphenylene, and fluorene. Preferred are chrysene, picene, naphthalene, phenanthrene, triphenylene, and fluorene having a T₁ of 2.5 eV or more.

Moreover, the host material preferably has the following features.

(3-1) The host material contains at least one of a chrysene ring, a picene ring, a phenanthrene ring, a triphenylene ring, and a fluorene ring in its skeleton.

(3-2) The host material contains no SP³ carbon.

The above will be described below.

(3-1) The host material contains at least one of a chrysene ring, a picene ring, a phenanthrene ring, a triphenylene ring, and a fluorene ring in its skeleton.

The compound of the present embodiment contains a benzofluorene skeleton in its ligand. The benzofluorene skeleton has a highly planar structure. The iridium complex of the present embodiment and the host material interact with each other as described in (2-1) and (2-2) above; thus, the host material also preferably has a highly planar structure. This is because the presence of the highly planar structures allows highly planar moieties to approach each other through interaction. More specifically, the benzofluorene moiety of the iridium complex easily approaches the planar moiety of the host material. Thus, the intermolecular distance between the iridium complex and the host material should be reduced. The above effect leads to the effect of increasing the efficiency of energy transfer described in (2-1).

Examples of the highly planar structure include structures containing fused polycyclic rings each having three or more rings. Preferred examples thereof include structures composed of hydrocarbons and containing fused polycyclic rings, such as a chrysene ring, a picene ring, a phenanthrene ring, a triphenylene ring, and a fluorene ring, which are fused polycyclic rings each having a T₁ of 2.5 eV or more.

(3-2) The host material contains no SP³ carbon.

As described in (3-1) above, the compound of the present embodiment is a compound characterized in that the interaction and the light emission characteristics are improved by improving the distance between the compound and the host material. The host material is a material that contains no SP³ carbon, so that the distance from the iridium complex serving as a guest material can be reduced.

### [Specific Examples]

Specific examples of the host material are illustrated below, but of course, the host material is not limited thereto.

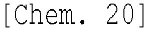

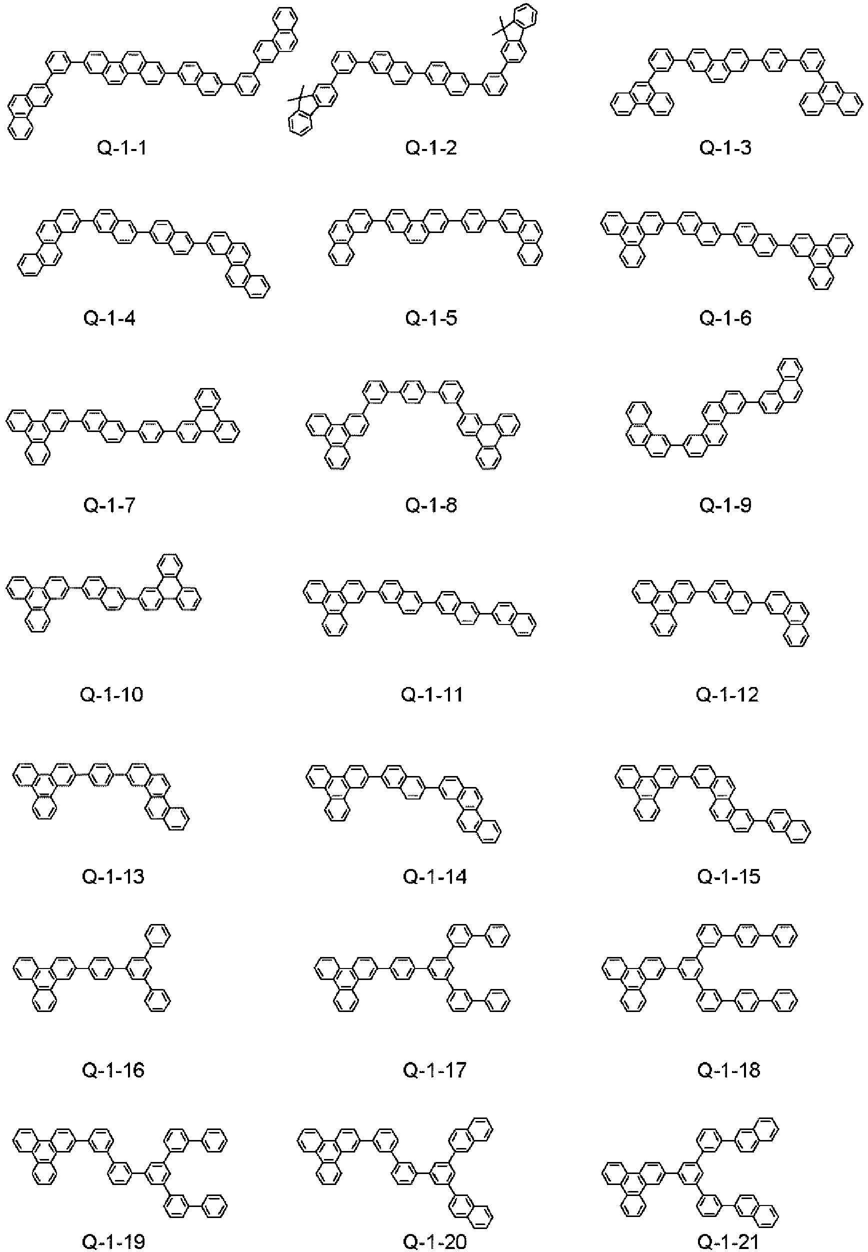

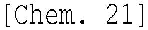

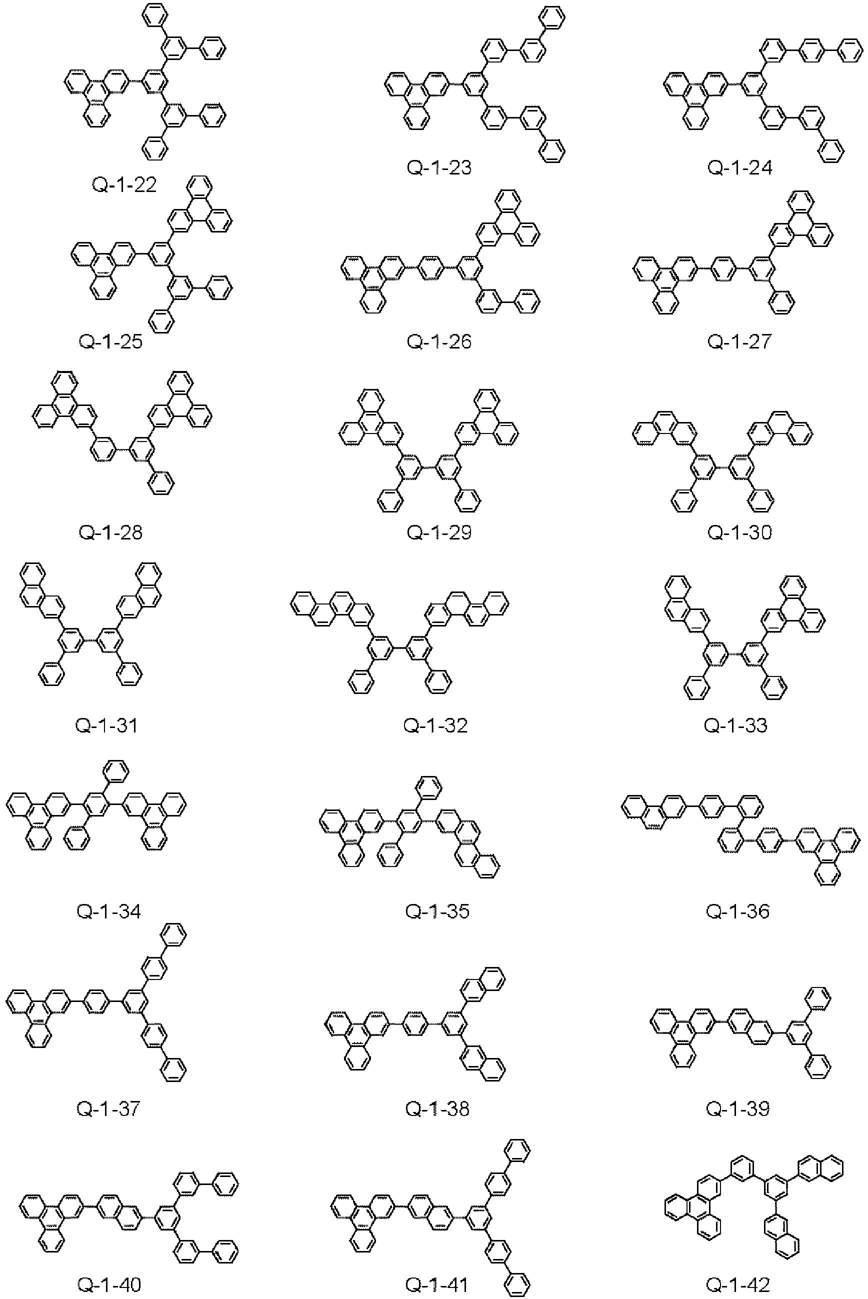

The above-mentioned exemplified compounds of the host compound are each a compound containing, in its skeleton, at least one of a triphenylene ring, a naphthalene ring, a phenanthrene ring, a chrysene ring, and a fluorene ring and containing no SP³ carbon. Thus, these compounds can each have a shorter distance from the compound of the present embodiment, so that each of the compounds serves as the host material that has a strong interaction and that satisfactorily transfers energy to the compound of the present embodiment. Of these, a compound containing a triphenylene ring in its skeleton has a high degree of planarity and is particularly preferred.

### <Assist Material>

Preferably, the light-emitting layer further contains an assist material. The assist material is preferably a compound that partially contains any of the following structures.

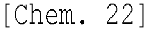

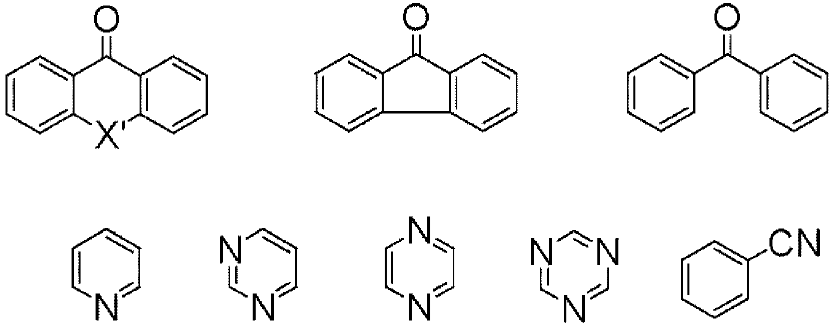

(In the above structure, X' is any one of an oxygen atom, a sulfur atom, and a substituted or unsubstituted carbon atom).

Each of the above structures is useful because it has electron-withdrawing properties and can lower the LUMO level of the assist material. The iridium complex represented by general formula [1] has a high HOMO level and thus tends to trap holes. However, the LUMO level is high, and thus it tends to be difficult to trap electrons. Therefore, the incorporation of an assist material having a low LUMO level into the light-emitting layer traps electrons in the light-emitting layer to provide a high-efficiency, long-life device having an appropriate carrier balance.

The above structures may be unsubstituted or may contain substituents. The carbon atom represented by X' may be unsubstituted or may have a substituent. Examples of the substituent include a halogen atom, an alkyl group, an alkoxy group, an aryloxy group, a heteroaryloxy group, an aryl group, a heterocyclic group, a silyl group, and an amino group.

Examples of the halogen atom include, but are not limited to, fluorine, chlorine, bromine, and iodine.

Examples of the alkyl group include, but are not limited to, a methyl group, an ethyl group, a n-propyl group, an isopropyl group, a n-butyl group, a tert-butyl group, a sec-butyl group, an octyl group, a cyclohexyl group, a 1-adamantyl group, and a 2-adamantyl group.

Examples of the alkoxy group include, but are not limited to, a methoxy group, an ethoxy group, a propoxy group, a 2-ethyl-octyloxy group, and a benzyloxy group.

Examples of the aryloxy group include, but are not limited to, a phenoxy group and a naphthoxy group.

Examples of the heteroaryloxy group include, but are not limited to, a furanyloxy group and a thienyloxy group.

Examples of the aryl group include, but are not limited to, a phenyl group, a naphthyl group, an indenyl group, a biphenyl group, a terphenyl group, a fluorenyl group, a phenanthryl group, a triphenylenyl group, a pyrenyl group, an anthranyl group, a perylenyl group, a chrysenyl group, and a fluoranthenyl group.

Examples of the heterocyclic group include, but are not limited to, a pyridyl group, a pyrimidyl group, a pyrazyl group, a triazyl group, a benzofuranyl group, a benzothiophenyl group, a dibenzofuranyl group, a dibenzothiophenyl group, an oxazolyl group, an oxadiazolyl group, a thiazolyl group, a thiadiazolyl group, a carbazolyl group, an acridinyl group, and a phenanthrolyl group.

Examples of the silyl group include, but are not limited to, a trimethylsilyl group and a triphenylsilyl group.

Examples of the amino group include, but are not limited to, an N-methylamino group, an N-ethylamino group, an N,N-dimethylamino group, an N,N-diethylamino group, an N-methyl-N-ethylamino group, an N-benzylamino group, an N-methyl-N-benzylamino group, an N,N-dibenzylamino group, an anilino group, an N,N-diphenylamino group, an N,N-dinaphthylamino group, an N,N-difluorenylamino group, an N-phenyl-N-tolylamino group, an N,N-ditolylamino group, an N-methyl-N-phenylamino group, an N,N-dianisolylamino group, an N-mesityl-N-phenylamino group, an N,N-dimesitylamino group, an N-phenyl-N-(4-tert-butylphenyl)amino group, an N-phenyl-N-(4-trifluoromethylphenyl)amino group, an N-piperidyl group, a carbazolyl group, and an acridyl group.

Examples of substituents that may further be contained in the alkyl group, the alkoxy group, the aryloxy group, the heteroaryloxy group, the aryl group, the heterocyclic group, the silyl group, and the amino group include, but are not limited to, deuterium; alkyl groups, such as a methyl group, an ethyl group, a n-propyl group, an isopropyl group, a n-butyl group, and a tert-butyl group; aralkyl groups, such as a benzyl group; aryl groups, such as a phenyl group and a biphenyl group; heterocyclic groups, such as a pyridyl group and a pyrrolyl group; amino groups, such as a dimethylamino group, a diethylamino group, a dibenzylamino group, a diphenylamino group, and a ditolylamino group: alkoxy groups, such as a methoxy group, an ethoxy group, and a propoxy group; aryloxy groups, such as a phenoxy group; halogen atoms, such as fluorine, chlorine, bromine, and iodine; and a cyano group.

### [Specific Examples]

Specific examples of the assist material are illustrated below, but of course, the assist material is not limited thereto.

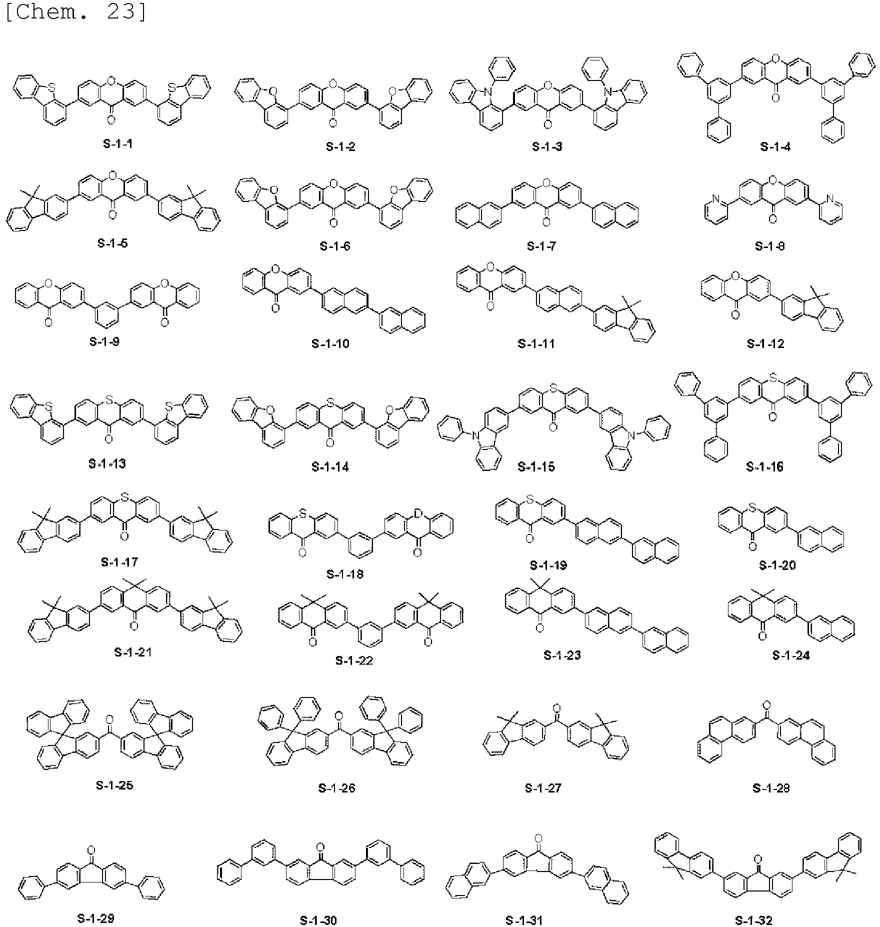

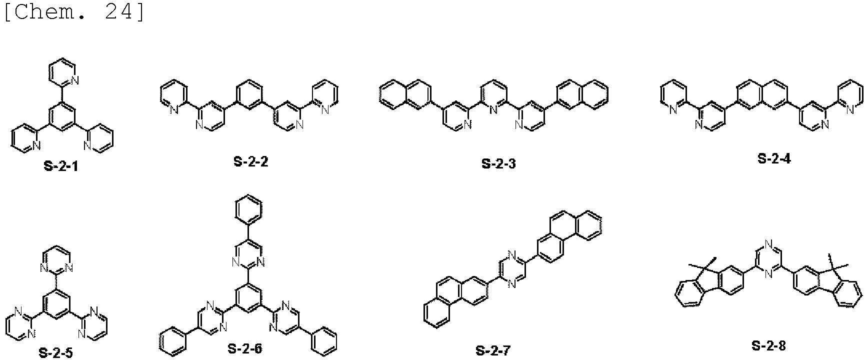

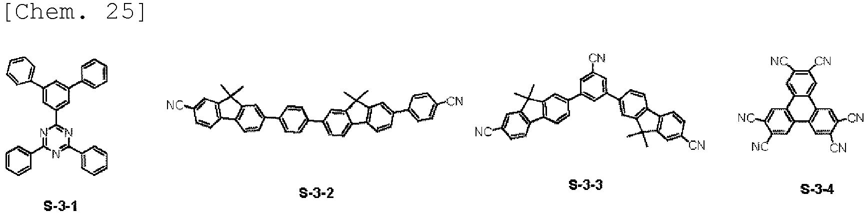

### <Other Materials>

In the light-emitting device of the present embodiment, for example, a hole injection compound, a hole transport compound, a compound to be used as a host, a light-emitting compound, an electron injection compound, or an electron transport compound, which is known and has a low or high molecular weight, can be used together with the organic compound of the present embodiment, as needed. Examples of these compounds are described below.

As a hole injection-transport material, a material having a high hole mobility is preferably used so as to facilitate the injection of holes from the anode and to transport the injected holes to the light-emitting layer. To inhibit a deterioration in film quality, such as crystallization, in the organic light-emitting device, a material having a high glass transition temperature is preferred. Examples of a low- or high-molecular-weight material having the ability to inject and transport holes include triarylamine derivatives, aryl carbazole derivatives, phenylenediamine derivatives, stilbene derivatives, phthalocyanine derivatives, porphyrin derivatives, poly(vinyl carbazole), poly(thiophene), and other conductive polymers. Moreover, the hole injection-transport material is also suitably used for the electron-blocking layer. Specific examples of a compound used as the hole injection-transport material are illustrated below, but of course, the compound is not limited thereto.

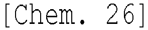

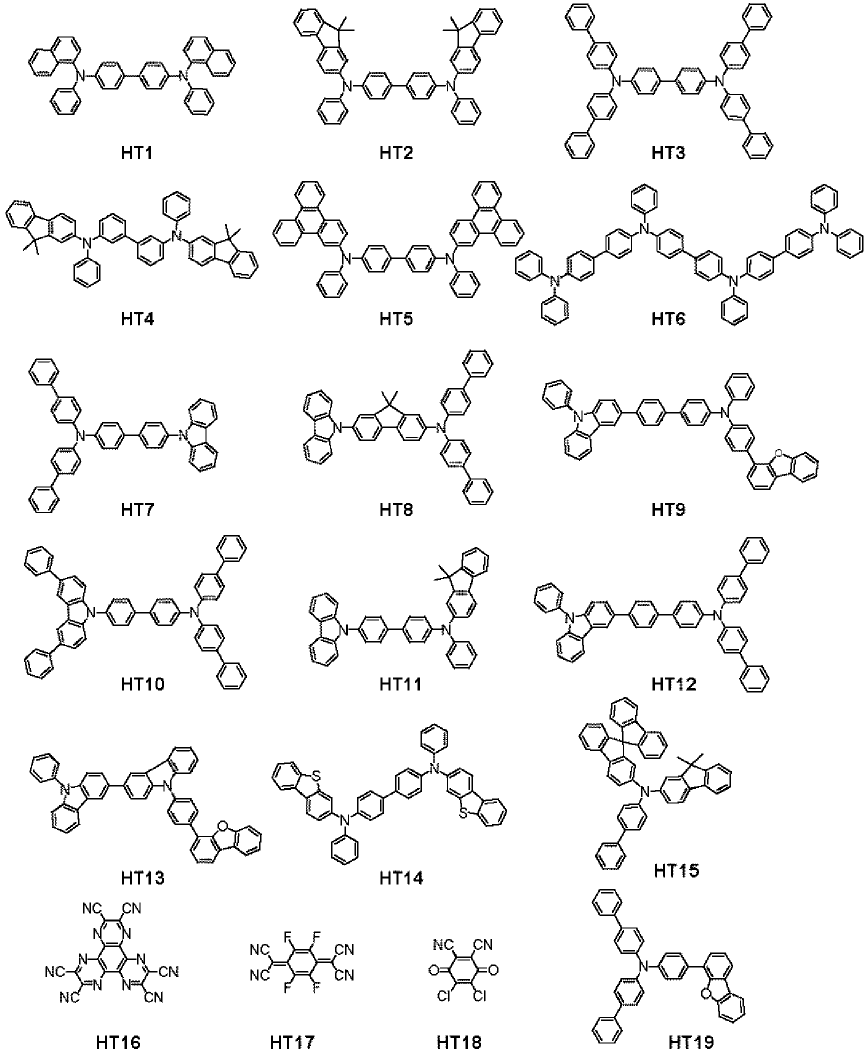

Among the hole transport materials illustrated above, HT16 to HT18 can be used in the layer in contact with the anode to reduce the driving voltage. HT16 is widely used in organic light-emitting devices. HT2 to HT6, HT10, and HT12 may be used in an organic compound layer adjacent to HT16. Multiple materials may be used in one organic compound layer.

Examples of the light-emitting dopant include fused-ring compounds (such as fluorene derivatives, naphthalene derivatives, pyrene derivatives, perylene derivatives, tetracene derivatives, anthracene derivatives, and rubrene), quinacridone derivatives, coumarin derivatives, stilbene derivatives, organoaluminum complexes, such as tris(8-quinolinolato)aluminum, iridium complexes, platinum complexes, rhenium complexes, copper complexes, europium complexes, ruthenium complexes, and polymer derivatives, such as poly(phenylene vinylene) derivatives, polyfluorene derivatives, and polyphenylene derivatives. Specific examples of a compound used as a light-emitting material are illustrated below, but of course, the light-emitting material is not limited thereto.

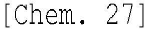

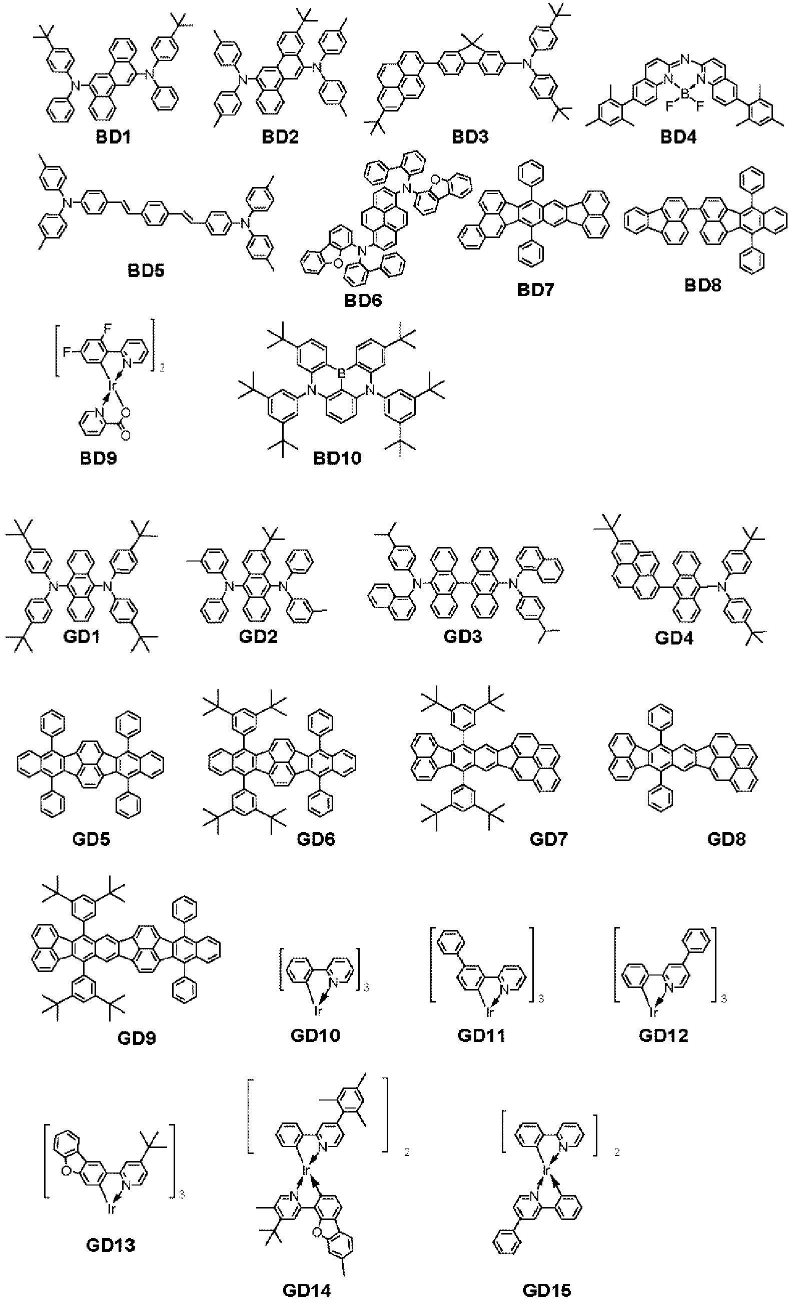

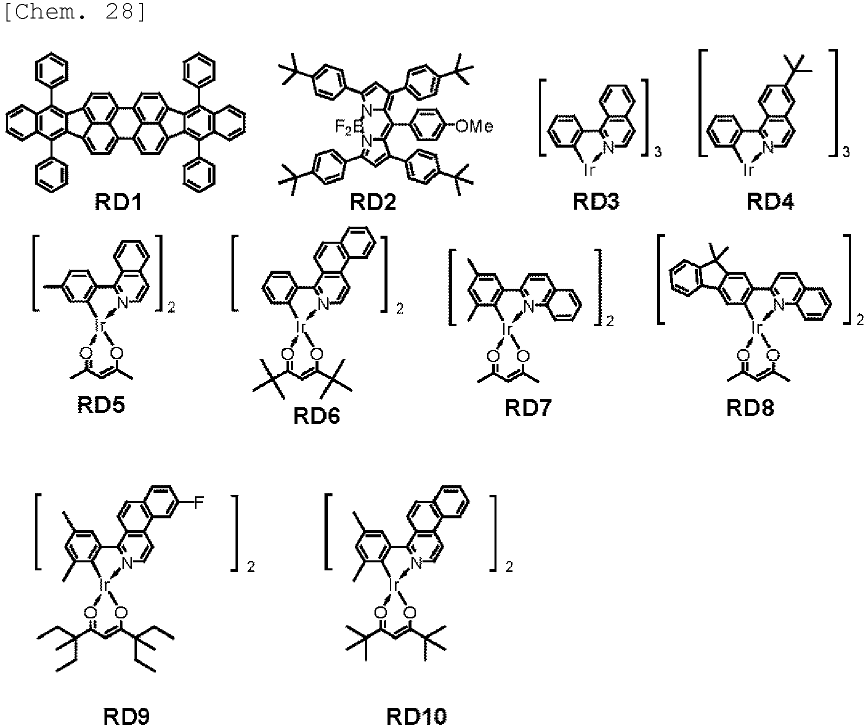

When the light-emitting material is a hydrocarbon compound, this compound is preferred because it reduces a decrease in luminous efficiency due to exciplex formation and a deterioration in color purity due to a change in the emission spectrum of the light-emitting material. The hydrocarbon compound is a compound consisting of only carbon and hydrogen, and BD7, BD8, GD5 to GD9, and RD1 are categorized thereinto. When the light-emitting material is a fused polycyclic compound containing a five-membered ring, this compound is more preferred because it has a high ionization potential and high resistance to oxidation, thus providing a highly durable device with a long lifetime. BD7, BD8, GD5 to GD9, and RD1 are categorized thereinto.

Examples of the host material or the assist material include aromatic hydrocarbon compounds and derivatives thereof, carbazole derivatives, dibenzofuran derivatives, dibenzothiophene derivatives, organoaluminum complexes, such as tris(8-quinolinolato)aluminum, and organoberyllium complexes. Specific examples of the compound are illustrated below, but of course, the compound is not limited thereto.

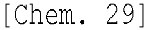

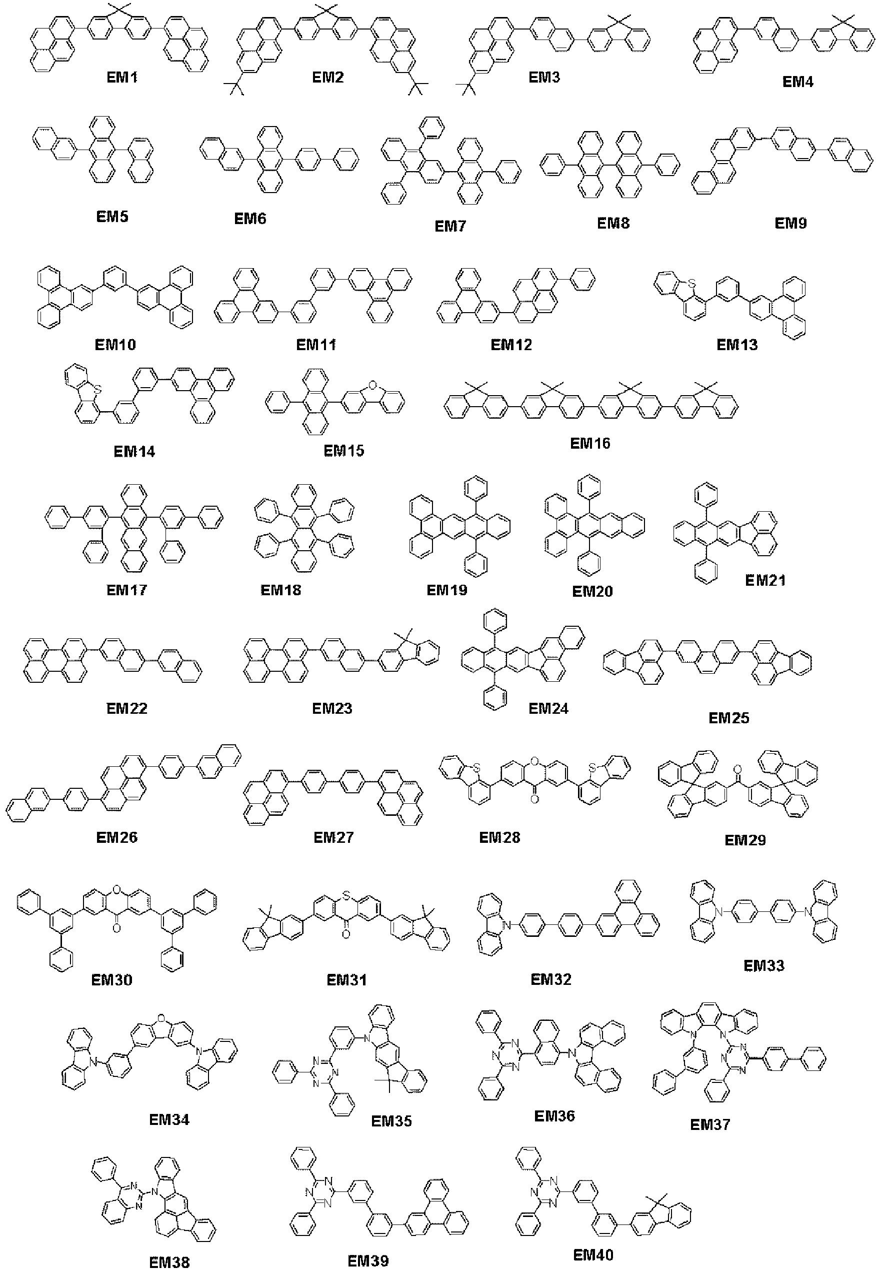

When the host material is a hydrocarbon compound, this compound is preferred because the compound of the present embodiment easily traps electrons and holes to contribute greatly to higher efficiency. The hydrocarbon compound is a compound consisting of only carbon and hydrogen, and EM1 to EM12 and EM16 to EM27 are categorized thereinto.

The electron transport material can be freely-selected from materials that can transport electrons injected from the cathode to the light-emitting layer, and is selected in consideration of, for example, the balance with the hole mobility of the hole transport material. Examples of a material having the ability to transport electrons include oxadiazole derivatives, oxazole derivatives, pyrazine derivatives, triazole derivatives, triazine derivatives, quinoline derivatives, quinoxaline derivatives, phenanthroline derivatives, organoaluminum complexes, and fused-ring compounds, such as fluorene derivatives, naphthalene derivatives, chrysene derivatives, and anthracene derivatives. The above-described electron transport materials are also suitably used for the hole-blocking layer. Specific examples of a compound used as the electron transport material are illustrated below, but of course, the electron transport material is not limited thereto.

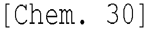

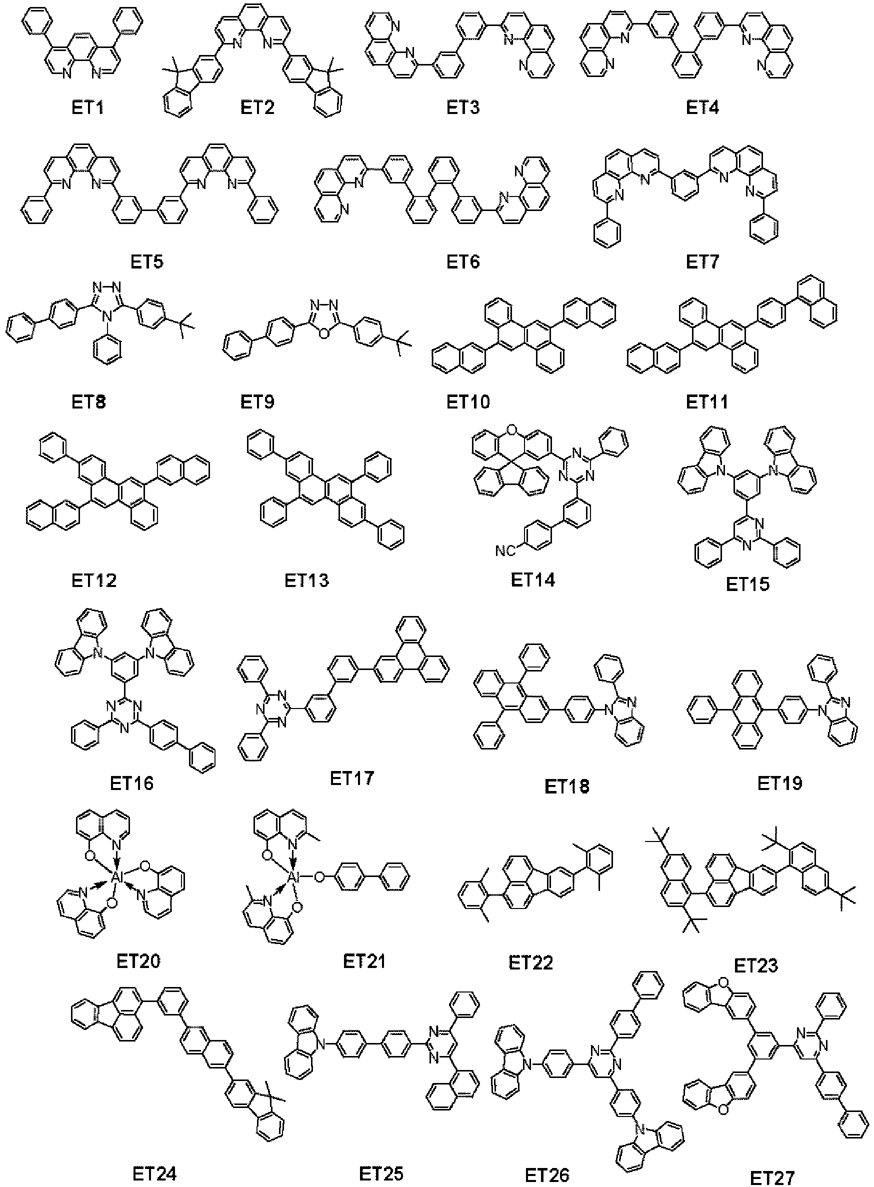

An electron injection material can be freely-selected from materials that can easily inject electrons from the cathode, and is selected in consideration of, for example, the balance with the hole injectability. As the organic compound, n-type dopants and reducing dopants are also included. Examples thereof include alkali metal-containing compounds, such as lithium fluoride, lithium complexes, such as lithium quinolinolate, benzimidazolidene derivatives, imidazolidene derivatives, fulvalene derivatives, and acridine derivatives.

### <Configuration of Organic Light-Emitting Device>

The organic light-emitting device includes an insulating layer, a first electrode, an organic compound layer, a second electrode over a substrate. A protective layer, a color filter, a microlens may be disposed over the second electrode. In the case of disposing the color filter, a planarization layer may be disposed between the protective layer and the color filter. The planarization layer can be composed of, for example, an acrylic resin. The same applies when a planarization layer is provided between the color filter and the microlens.

### [Substrate]

Examples of the substrate include silicon wafers, quartz substrates, glass substrates, resin substrates, and metal substrates. The substrate may include a switching device, such as a transistor, a line, and an insulating layer thereon. Any material can be used for the insulating layer as long as a contact hole can be formed in such a manner that a line can be coupled to the first electrode and as long as insulation with a non-connected line can be ensured. For example, a resin, such as polyimide, silicon oxide, or silicon nitride, can be used.

### [Electrode]

A pair of electrodes can be used. The pair of electrodes is the first electrode and the second electrode, which may be an anode and a cathode, respectively.

When an electric field is applied in the direction in which the organic light-emitting device emits light, an electrode having a higher potential is the anode, and the other is the cathode. It can also be said that the electrode that supplies holes to the light-emitting layer is the anode and that the electrode that supplies electrons is the cathode.

As the component material of the anode, a material having a work function as high as possible can be used. Examples of the material that can be used include elemental metals, such as gold, platinum, silver, copper, nickel, palladium, cobalt, selenium, vanadium, and tungsten, mixtures thereof, alloys of combinations thereof, and metal oxides, such as tin oxide, zinc oxide, indium oxide, indium-tin oxide (ITO), and indium-zinc oxide. Additionally, conductive polymers, such as polyaniline, polypyrrole, and polythiophene, can be used.

These electrode materials may be used alone or in combination of two or more. The anode may be formed of a single layer or multiple layers.

When the anode is used as a reflective electrode, for example, chromium, aluminum, silver, titanium, tungsten, molybdenum, an alloy thereof, or a stack thereof can be used. These materials can also be used to act as a reflective film that does not have the role of an electrode. When the anode is used as a transparent electrode, a transparent conductive oxide layer composed of, for example, indium-tin oxide (ITO) or indium-zinc oxide can be used; however, the anode is not limited thereto.

The electrode can be formed by photolithography.

As the component material of the cathode, a material having a lower work function can be used. Examples thereof include elemental metals such as alkali metals, e.g., lithium, alkaline-earth metals, e.g., calcium, aluminum, titanium, manganese, silver, lead, and chromium, and mixtures thereof. Alloys of combinations of these elemental metals can also be used. For example, magnesium-silver, aluminum-lithium, aluminum-magnesium, silver-copper, and zinc-silver can be used. Metal oxides, such as indium-tin oxide (ITO), can also be used. These electrode materials may be used alone or in combination of two or more. The cathode may have a single-layer structure or a multilayer structure. Among them, it is preferable to use silver. To reduce the aggregation of silver, it is more preferable to use a silver alloy. Any alloy ratio may be used as long as the aggregation of silver can be reduced. The ratio of silver to another metal may be, for example, 1:1 or 3:1.

A top emission device may be provided using the cathode formed of a conductive oxide layer composed of, for example, ITO. A bottom emission device may be provided using the cathode formed of a reflective electrode composed of, for example, aluminum (Al). Any type of cathode may be used. Any method for forming the cathode may be employed. For example, a direct-current or alternating-current sputtering technique is more preferably employed because good film coverage is obtained and thus the resistance is easily reduced.

### [Organic Compound Layer]

The organic compound layer may be formed of a single layer or multiple layers. When multiple layers are present, they may be referred to as a hole injection layer, a hole transport layer, an electron-blocking layer, a light-emitting layer, a hole-blocking layer, an electron transport layer, or an electron injection layer in accordance with their functions. The organic compound layer is mainly composed of an organic compound, and may contain inorganic atoms and an inorganic compound. For example, the organic compound layer may contain, for example, copper, lithium, magnesium, aluminum, iridium, platinum, molybdenum, or zinc. The organic compound layer may be disposed between the first electrode and the second electrode, and may be disposed in contact with the first electrode and the second electrode.

The organic compound layer, such as the hole injection layer, the hole transport layer, the electron-blocking layer, the light-emitting layer, the hole-blocking layer, the electron transport layer, or the electron injection layer, included in the organic light-emitting device according to an embodiment of the present invention is formed by a method described below.

For the organic compound layer included in the organic light-emitting device according to an embodiment of the present invention, a dry process, such as a vacuum evaporation method, an ionized evaporation method, sputtering, or plasma, may be employed. Alternatively, instead of the dry process, it is also possible to employ a wet process in which a material is dissolved in an appropriate solvent and then a film is formed by a known coating method, such as spin coating, dipping, a casting method, an LB technique, or an ink jet method.

When the layer is formed by, for example, the vacuum evaporation method or the solution coating method, crystallization and so forth are less likely to occur, and good stability with time is obtained. In the case of forming a film by the coating method, the film may be formed in combination with an appropriate binder resin.

Examples of the binder resin include, but are not limited to, poly(vinyl carbazole) resins, polycarbonate resins, polyester resins, ABS resins, acrylic resins, polyimide resins, phenolic resins, epoxy resins, silicon resins, and urea resins.

These binder resins may be used alone as a homopolymer or copolymer or in combination as a mixture of two or more. Furthermore, additives, such as a known plasticizer, antioxidant, and ultraviolet absorber, may be used, as needed.

### [Protective Layer]

A protective layer may be disposed on the second electrode. For example, a glass member provided with a moisture absorbent can be bonded to the second electrode to reduce the entry of, for example, water into the organic compound layer, thereby reducing the occurrence of display defects. In another embodiment, a passivation film composed of, for example, silicon nitride may be disposed on the second electrode to reduce the entry of, for example, water into the organic compound layer. For example, after the formation of the second electrode, the substrate may be transported to another chamber without breaking the vacuum, and a silicon nitride film having a thickness of 2 um may be formed by a CVD method to provide a protective layer. After the film deposition by the CVD method, a protective layer may be formed by an atomic layer deposition (ALD) method. Examples of the material of the layer formed by the ALD method may include, but are not limited to, silicon nitride, silicon oxide, and aluminum oxide. Silicon nitride may be deposited by the CVD method on the layer formed by the ALD method. The film formed by the ALD method may have a smaller thickness than the film formed by the CVD method. Specifically, the thickness may be 50% or less, even 10% or less.

### [Color Filter]

A color filter may be disposed on the protective layer. For example, a color filter may be disposed on another substrate in consideration of the size of the organic light-emitting device and bonded to the substrate provided with the organic light-emitting device. A color filter may be formed by patterning on the protective layer using photolithography. The color filter may be composed of a polymer.

### [Planarization Layer]

A planarization layer may be disposed between the color filter and the protective layer. The planarization layer is provided for the purpose of reducing the unevenness of the layer underneath. The planarization layer may be referred to as a "material resin layer" without limiting its purpose. The planarization layer may be composed of an organic compound. A low- or high-molecular-weight organic compound may be used. A high-molecular-weight organic compound is preferred.

The planarization layers may be disposed above and below (or on) the color filter and may be composed of the same or different component materials. Specific examples thereof include poly(vinyl carbazole) resins, polycarbonate resins, polyester resins, ABS resins, acrylic resins, polyimide resins, phenolic resins, epoxy resins, silicon resins, and urea resins.

### [Microlens]

The organic light-emitting device or an organic light-emitting apparatus may include an optical component, such as a microlens, on the outgoing light side. The microlens can be composed of, for example, an acrylic resin or an epoxy resin. The microlens may be used to increase the amount of light emitted from the organic light-emitting device or the organic light-emitting apparatus and to control the direction of the light emitted. The microlens may have a hemispherical shape. In the case of a hemispherical shape, among tangents to the hemisphere, there is a tangent parallel to the insulating layer. The point of contact of the tangent with the hemisphere is the vertex of the microlens. The vertex of the microlens can be determined in the same way for any cross-sectional view. That is, among the tangents to the semicircle of the microlens in the cross-sectional view, there is a tangent parallel to the insulating layer, and the point of contact of the tangent with the semicircle is the vertex of the microlens.

The midpoint of the microlens can be defined. In the cross section of the microlens, when a segment is hypothetically drawn from the point where an arc shape ends to the point where another arc shape ends, the midpoint of the segment can be referred to as the midpoint of the microlens. The cross section to determine the vertex and midpoint may be a cross section perpendicular to the insulating layer.

### [Opposite Substrate]

An opposite substrate may be disposed on the planarization layer. The opposite substrate is disposed at a position corresponding to the substrate described above and thus is called an opposite substrate. The opposite substrate may be composed of the same material as the substrate described above. When the above-described substrate is referred to as a first substrate, the opposite substrate may be referred to as a second substrate.

### [Pixel Circuit]

An organic light-emitting apparatus including organic light-emitting devices may include pixel circuits coupled to the organic light-emitting devices. Each of the pixel circuits may be of an active matrix type, which independently controls the emission of first and second light-emitting devices. The active matrix type circuit may be voltage programming or current programming. A driving circuit includes the pixel circuit for each pixel. The pixel circuit may include a light-emitting device, a transistor to control the luminance of the light-emitting device, a transistor to control the timing of the light emission, a capacitor to retain the gate voltage of the transistor to control the luminance, and a transistor to connect to GND without using the light-emitting device.

The light-emitting apparatus includes a display area and a peripheral area disposed around the display area. The display area includes a pixel circuit, and the peripheral area includes a display control circuit. The mobility of a transistor contained in the pixel circuit may be lower than the mobility of a transistor contained in the display control circuit. The gradient of the current-voltage characteristics of the transistor contained in the pixel circuit may be smaller than the gradient of the current-voltage characteristic of the transistor contained in the display control circuit. The gradient of the current-voltage characteristics can be measured by what is called Vg-Ig characteristics. The transistor contained in the pixel circuit is a transistor coupled to a light-emitting device, such as a first light-emitting device.

### [Pixel]

An organic light-emitting apparatus including an organic light-emitting device may include multiple pixels. Each pixel includes subpixels configured to emit colors different from each other. The subpixels may have respective red, green, and blue (RGB) emission colors.

Light emerges from a region of the pixel, also called a pixel aperture. This region is the same as a first region. The pixel aperture may be 15 um or less, and may be 5 um or more. More specifically, the pixel aperture may be, for example, 11 um, 9.5 um, 7.4 um, or 6.4 um. The distance between subpixels may be 10 um or less. Specifically, the distance may be 8 um, 7.4 um, or 6.4 µm.

The pixels may be arranged in a known pattern in plan view. For example, a stripe pattern, a delta pattern, a Pen Tile matrix pattern, or the Bayer pattern may be used. The shape of each subpixel in plan view may be any known shape. Examples of the shape of the subpixel include quadrilaterals, such as rectangles and rhombi, and hexagons. Of course, if the shape is close to a rectangle, rather than an exact shape, it is included in the rectangle. The shape of the subpixel and the pixel arrangement can be used in combination.

### <Application of Organic Light-Emitting Device>

The organic light-emitting device according to an embodiment can be used as a component member of a display apparatus or lighting apparatus. Other applications include exposure light sources for electrophotographic image-forming apparatuses, backlights for liquid crystal displays, and light-emitting apparatuses including white-light sources and color filters.

The display apparatus may be an image information-processing unit having an image input unit that receives image information from an area CCD, a linear CCD, a memory card, or the like, an information-processing unit that processes the input information, and a display unit that displays the input image. The display apparatus includes multiple pixels, and at least one of the multiple pixels may include the organic light-emitting device of the present embodiment and a transistor coupled to the organic light-emitting device.

The display unit of an image pickup apparatus or an inkjet printer may have a touch panel function. The display unit of an image pickup apparatus or an inkjet printer may have a touch panel function. The driving mode of the touch panel function may be, but is not particularly limited to, an infrared mode, an electrostatic capacitance mode, a resistive film mode, or an electromagnetic inductive mode. The display apparatus may also be used for a display unit of a multifunction printer.

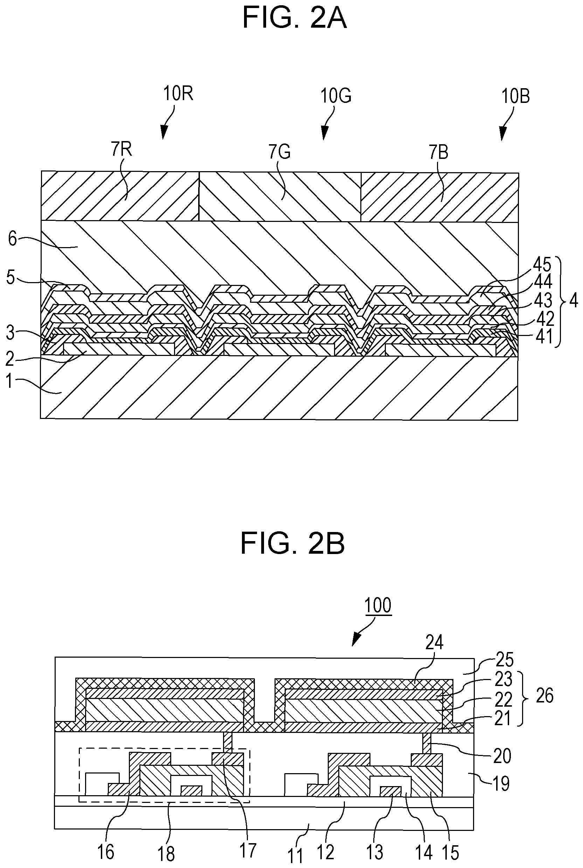

The following describes a display apparatus according to the present embodiment with reference to the attached drawings. Figs. 2A and 2B are each a schematic cross-sectional view of an example of a display apparatus including organic light-emitting devices and transistors coupled to the respective organic light-emitting devices. Each of the transistors is an example of an active element. The transistors may be thin-film transistors (TFTs).

Fig. 2A is an example of pixels that are components of the display apparatus according to the present embodiment. Each of the pixels includes subpixels 10. The subpixels are separated into 10R, 10G, and 10B according to their light emission. The emission color may be distinguished based on the wavelength of light emitted from the light-emitting layer. Alternatively, light emitted from the subpixels may be selectively transmitted or color-converted with, for example, a color filter. Each subpixels 10 includes a reflective electrode serving as a first electrode 2, an insulating layer 3 covering the edge of the first electrode 2, an organic compound layer 4 covering the first electrode 2 and the insulating layer 3, a transparent electrode serving as a second electrode 5, a protective layer 6, and a color filter 7 over an interlayer insulating layer 1.

The transistors and capacitive elements may be disposed under or in the interlayer insulating layer 1. Each transistor may be electrically coupled to a corresponding one of the first electrodes 2 through a contact hole, which is not illustrated.

The insulating layer 3 is also called a bank or pixel separation film. The insulating layer 3 covers the edge of each first electrode 2 and surrounds the first electrode 2. Portions that are not covered with the insulating layer 3 are in contact with the organic compound layer 4 and serve as light-emitting regions.

The organic compound layer 4 includes a hole injection layer 41, a hole transport layer 42, a first light-emitting layer 43, a second light-emitting layer 44, and an electron transport layer 45.

The second electrode 5 may be a transparent electrode, a reflective electrode, or a semi-transparent electrode.

The protective layer 6 reduces the penetration of moisture into the organic compound layer 4. Although the protective layer 6 is illustrated as a single layer, the protective layer 6 may include multiple layers, and each layer may be an inorganic compound layer or an organic compound layer.

The color filter 7 is separated into 7R, 7G, and 7B according to its color. The color filter 7 may be disposed on a planarization film, which is not illustrated. A resin protective layer, not illustrated, may be disposed on the color filter 7. The color filter 7 may be disposed on the protective layer 6. Alternatively, the color filter 7 may be disposed on an opposite substrate, such as a glass substrate, and then bonded.

A display apparatus 100 illustrated in Fig. 2B includes organic light-emitting devices 26 and TFTs 18 as an example of transistors. A substrate 11 composed of a material, such as glass or silicon is provided, and an insulating layer 12 is disposed thereon. Active elements, such as the TFTs 18, are disposed on the insulating layer 12. The gate electrode 13, the gate insulating film 14, and the semiconductor layer 15 of each of the active elements are disposed thereon. Each TFT 18 further includes a drain electrode 16 and a source electrode 17. The TFTs 18 are overlaid with an insulating film 19. Anode 21 included in the organic light-emitting devices 26 is coupled to the source electrodes 17 through contact holes 20 provided in the insulating film 19.

The mode of electrical connection between the electrodes (anode 21 and cathode 23) included in each organic light-emitting device 26 and the electrodes (source electrode 17 and drain electrode 16) included in a corresponding one of the TFTs 18 is not limited to the mode illustrated in Fig. 2B. That is, it is sufficient that any one of the anode 21 and the cathode 23 is electrically coupled to any one of the source electrode 17 and the drain electrode 16 of the TFT 18. The term "TFT" refers to a thin-film transistor.

In the display apparatus 100 illustrated in Fig. 2B, although each organic compound layer 22 is illustrated as a single layer, the organic compound layer 22 may include multiple layers. To reduce the deterioration of the organic light-emitting devices 26, a first protective layer 24 and a second protective layer 25 are disposed on the cathodes 23.

In the display apparatus 100 illustrated in Fig. 2B, although the transistors are used as switching devices, other switching devices may be used instead.

The transistors used in the display apparatus 100 illustrated in Fig. 2B are not limited to transistors using a single-crystal silicon wafer, but may also be thin-film transistors including active layers on the insulating surface of a substrate. Examples of the material of the active layers include single-crystal silicon, non-single-crystal silicon, such as amorphous silicon and microcrystalline silicon; and non-single-crystal oxide semiconductors, such as indium zinc oxide and indium gallium zinc oxide. Thin-film transistors are also called TFT elements.

The transistors in the display apparatus 100 illustrated in Fig. 2B may be formed in the substrate, such as a Si substrate. The expression "formed in the substrate" indicates that the transistors are produced by processing the substrate, such as a Si substrate. In the case where the transistors are formed in the substrate, the substrate and the transistors can be deemed to be integrally formed.

In the organic light-emitting device according to the present embodiment, the luminance is controlled by the TFT devices, which are an example of switching devices; thus, an image can be displayed at respective luminance levels by arranging multiple organic light-emitting devices in the plane. The switching devices according to the present embodiment are not limited to the TFT devices and may be low-temperature polysilicon transistors or active-matrix drivers formed on a substrate such as a Si substrate. The expression "on a substrate" can also be said to be "in the substrate". Whether transistors are formed in the substrate or TFT devices are used is selected in accordance with the size of a display unit. For example, when the display unit has a size of about 0.5 inches, organic light-emitting devices are preferably disposed on a Si substrate.

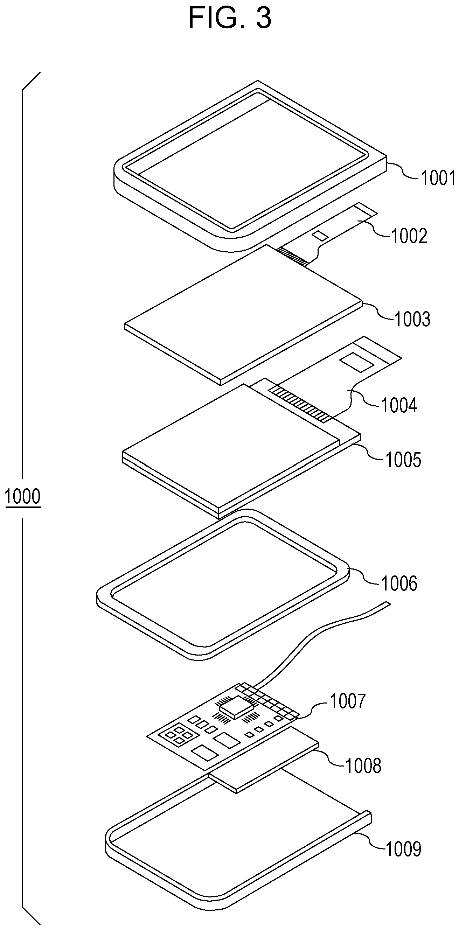

Fig. 3 is a schematic view illustrating an example of a display apparatus according to the present embodiment. A display apparatus 1000 may include a touch panel 1003, a display panel 1005, a frame 1006, a circuit substrate 1007, and a battery 1008 disposed between an upper cover 1001 and a lower cover 1009. The touch panel 1003 and the display panel 1005 are coupled to flexible printed circuits FPCs 1002 and 1004, respectively. The circuit substrate 1007 includes printed transistors. The battery 1008 need not be provided unless the display apparatus is a portable apparatus. The battery 1008 may be disposed at a different position even if the display apparatus is a portable apparatus.

The display apparatus according to the present embodiment may include a color filter having red, green, and blue portions. In the color filter, the red, green, and blue portions may be arranged in a delta arrangement.

The display apparatus according to the present embodiment may be used for the display unit of a portable terminal. In that case, the display apparatus may have both a display function and an operation function. Examples of the portable terminal include mobile phones such as smartphones, tablets, and head-mounted displays.

The display apparatus according to the present embodiment may be used for a display unit of an image pickup apparatus including an optical unit including multiple lenses and an image pickup device that receives light passing through the optical unit. The image pickup apparatus may include a display unit that displays information acquired by the image pickup device. The display unit may be a display unit exposed to the outside of the image pickup apparatus or a display unit disposed in a finder. The image pickup apparatus may be a digital camera or a digital camcorder.

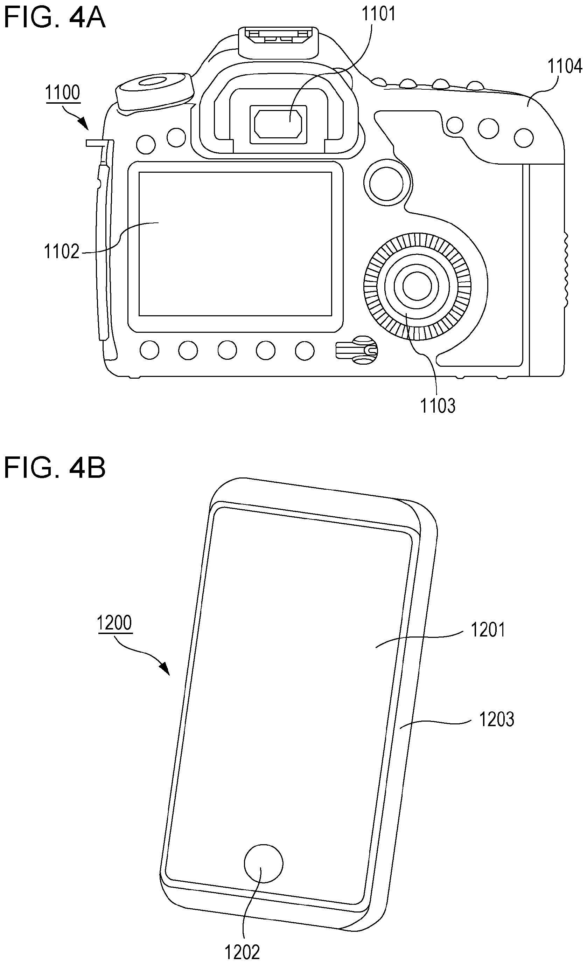

Fig. 4A is a schematic view illustrating an example of an image pickup apparatus according to the present embodiment. An image pickup apparatus 1100 may include a viewfinder 1101, a rear display 1102, an operation unit 1103, and a housing 1104. The viewfinder 1101 may include the display apparatus according to the present embodiment. In this case, the display apparatus may display environmental information, imaging instructions, and so forth in addition to an image to be captured. The environmental information may include, for example, the intensity of external light, the direction of external light, the moving speed of a subject, and the possibility that a subject is shielded by a shielding material.

The timing suitable for imaging is only for a short time; thus, the information may be displayed as soon as possible. Accordingly, it is preferable to use a display apparatus including the organic light-emitting device of the present embodiment. This is because the organic light-emitting device has a fast response time. The display apparatus including the organic light-emitting device can be used more suitably than liquid crystal displays for such apparatuses required to have a high display speed.

The image pickup apparatus 1100 includes an optical unit, which is not illustrated. The optical unit includes multiple lenses and is configured to form an image on an image pickup device in the housing 1104. The relative positions of the multiple lenses can be adjusted to adjust the focal point. This operation can also be performed automatically. The image pickup apparatus may translate to a photoelectric conversion apparatus. Examples of an image capturing method employed in the photoelectric conversion apparatus may include a method for detecting a difference from the previous image and a method of cutting out an image from images always recorded, instead of sequentially capturing images.

Fig. 4B is a schematic view illustrating an example of an electronic apparatus according to the present embodiment. An electronic apparatus 1200 includes a display unit 1201, an operation unit 1202, and a housing 1203. The housing 1203 may accommodate a circuit, a printed circuit board including the circuit, a battery, and a communication unit. The operation unit 1202 may be a button or a touch-screen-type reactive unit. The operation unit 1202 may be a biometric recognition unit that recognizes a fingerprint to release the lock or the like. An electronic apparatus having a communication unit can also be referred to as a communication apparatus. The electronic apparatus 1200 may further have a camera function by being equipped with a lens and an image pickup device. An image captured by the camera function is displayed on the display unit 1201. Examples of the electronic apparatus 1200 include smartphones and notebook computers.

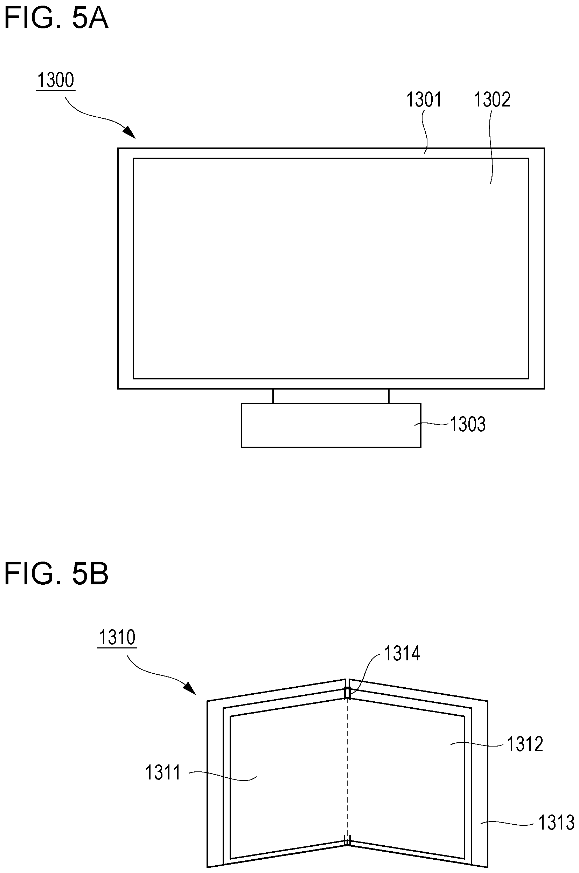

Figs. 5A and 5B are each a schematic view illustrating an example of the display apparatus according to the present embodiment. Fig. 5A illustrates a display apparatus, such as a television monitor or a PC monitor. A display apparatus 1300 includes a frame 1301 and a display unit 1302. The light-emitting device according to the present embodiment may be used for the display unit 1302. The display apparatus 1300 includes a base 1303 that supports the frame 1301 and the display unit 1302. The base 1303 is not limited to the structure illustrated in Fig. 5A. The lower side of the frame 1301 may also serve as a base. The frame 1301 and the display unit 1302 may be curved. These may have a radius of curvature of 5,000 mm or more and 6,000 mm or less.

Fig. 5B is a schematic view illustrating another example of a display apparatus according to the present embodiment. A display apparatus 1310 illustrated in Fig. 5B can be folded and is what is called a foldable display apparatus. The display apparatus 1310 includes a first display portion 1311, a second display portion 1312, a housing 1313, and an inflection point 1314. The first display portion 1311 and the second display portion 1312 may include the light-emitting device according to the present embodiment. The first display portion 1311 and the second display portion 1312 may be a single, seamless display apparatus. The first display portion 1311 and the second display portion 1312 can be divided from each other at the inflection point. The first display portion 1311 and the second display portion 1312 may display different images. Alternatively, a single image may be displayed in the first and second display portions.

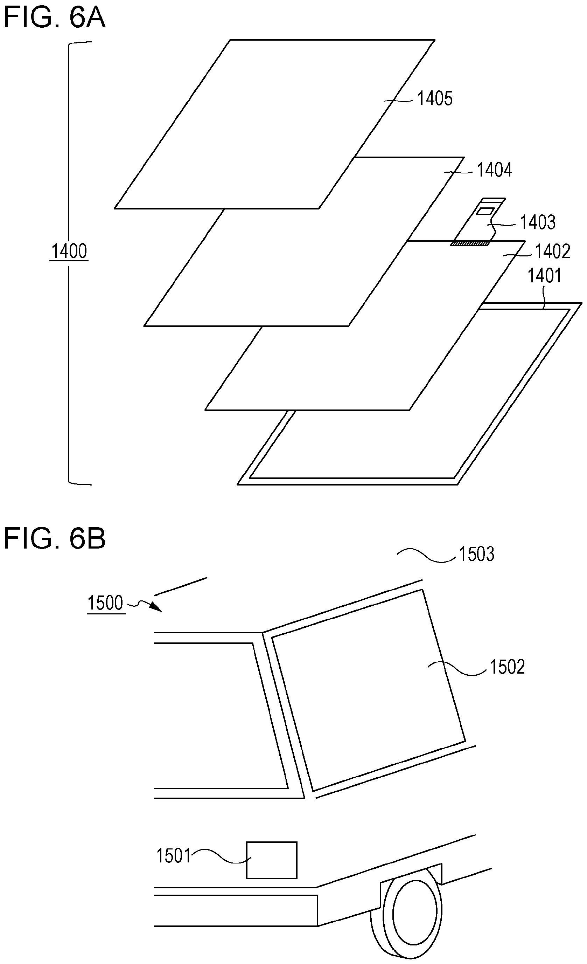

Fig. 6A is a schematic view illustrating an example of a lighting apparatus according to the present embodiment. A lighting apparatus 1400 may include a housing 1401, a light source 1402, a circuit board 1403, an optical filter 1404 that transmits light emitted from the light source 1402, and a light diffusion unit 1405. The light source 1402 may include an organic light-emitting device according to the present embodiment. The optical filter 1404 may be a filter that improves the color rendering properties of the light source. The light diffusion unit 1405 can effectively diffuse light from the light source to deliver the light to a wide range when used for illumination and so forth. The optical filter 1404 and the light diffusion unit 1405 may be disposed at the light emission side of the lighting apparatus. A cover may be disposed at the outermost portion, as needed.

The lighting apparatus is, for example, an apparatus that lights a room. The lighting apparatus may emit light of white, neutral white, or any color from blue to red. A light control circuit that controls the light may be provided. The lighting apparatus may include the organic light-emitting device of the present embodiment and a power supply circuit coupled thereto. The power supply circuit is a circuit that converts an AC voltage into a DC voltage. The color temperature of white is 4,200 K, and the color temperature of neutral white is 5,000 K. The lighting apparatus may include a color filter.

The lighting apparatus according to the present embodiment may include a heat dissipation unit. The heat dissipation unit is configured to release heat in the device to the outside of the device and is composed of, for example, a metal having a high specific heat and liquid silicon.

Fig. 6B is a schematic view illustrating an automobile as an example of a moving object according to the present embodiment. The automobile includes a tail lamp, which is an example of lighting units. An automobile 1500 includes a tail lamp 1501 and may be configured to light the tail lamp when a brake operation or the like is performed.

The tail lamp 1501 may include an organic light-emitting device according to the present embodiment. The tail lamp 1501 may include a protective member that protects the organic light-emitting device. The protective member may be composed of any transparent material with some degree of high strength and is preferably composed of polycarbonate, for example. The polycarbonate may be mixed with, for example, a furandicarboxylic acid derivative or an acrylonitrile derivative.

The automobile 1500 may include an automobile body 1503 and windows 1502 attached thereto. The windows 1502 may be transparent displays if the windows are not used to check the front and back of the automobile. The transparent displays may include an organic light-emitting device according to the present embodiment.

In this case, the components, such as the electrodes, of the organic light-emitting device are formed of transparent members.

The moving object according to the present embodiment may be, for example, a ship, an aircraft, or a drone. The moving object may include a body and a lighting unit attached to the body. The lighting unit may emit light to indicate the position of the body. The lighting unit includes the organic light-emitting device according to the present embodiment.

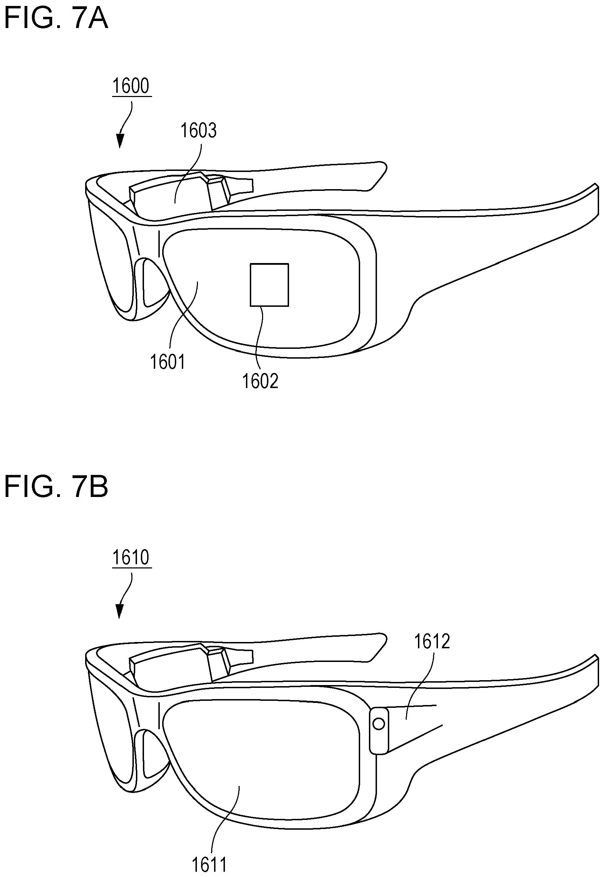

Examples of applications of the display apparatuses of the above embodiments will be described with reference to Figs. 7A and 7B. The display apparatuses can be used for systems that can be worn as wearable devices, such as smart glasses, HMDs, and smart contacts. An image pickup and display apparatus used in such an example of the applications has an image pickup apparatus that can photoelectrically convert visible light and a display apparatus that can emit visible light.

Fig. 7A is a schematic view illustrating an example of a wearable device according to an embodiment of the present invention. Glasses 1600 (smart glasses) according to an example of applications will be described with reference to Fig. 7A. An image pickup apparatus 1602, such as a CMOS sensor or SPAD, is provided on a front side of a lens 1601 of the glasses 1600. The display apparatus according to any of the above-mentioned embodiments is provided on the back side of the lens 1601.

The glasses 1600 further include a control unit 1603. The control unit 1603 functions as a power source that supplies electric power to the image pickup apparatus 1602 and the display apparatus. The control unit 1603 controls the operation of the image pickup apparatus 1602 and the display apparatus. The lens 1601 has an optical system for focusing light on the image pickup apparatus 1602.

Fig. 7B is a schematic view illustrating another example of a wearable device according to an embodiment of the present invention. Glasses 1610 (smart glasses) according to an example of applications will be described with reference to Fig. 7B. The glasses 1610 include a control unit 1612. The control unit 1612 includes an image pickup apparatus corresponding to the image pickup apparatus 1602 illustrated in Fig. 7A and a display apparatus. A lens 1611 is provided with the image pickup apparatus in the control unit 1612 and an optical system that projects light emitted from the display apparatus. An image is projected onto the lens 1611. The control unit 1612 functions as a power source that supplies electric power to the image pickup apparatus and the display apparatus and controls the operation of the image pickup apparatus and the display apparatus.

The control unit 1612 may include a gaze detection unit that detects the gaze of a wearer. Infrared light may be used for gaze detection. An infrared light-emitting unit emits infrared light to an eyeball of a user who is gazing at a displayed image. An image of the eyeball is captured by detecting the reflected infrared light from the eyeball with an image pickup unit having light-receiving elements. The deterioration of image quality is reduced by providing a reduction unit that reduces light from the infrared light-emitting unit to the display unit when viewed in plan. The user's gaze at the displayed image is detected from the image of the eyeball captured with the infrared light. Any known method can be employed to the gaze detection using the captured image of the eyeball. As an example, a gaze detection method based on a Purkinje image of the reflection of irradiation light on a cornea can be employed. More specifically, the gaze detection process is based on a pupil-corneal reflection method. Using the pupil-corneal reflection method, the user's gaze is detected by calculating a gaze vector representing the direction (rotation angle) of the eyeball based on the image of the pupil and the Purkinje image contained in the captured image of the eyeball.

A display apparatus according to an embodiment of the present invention may include an image pickup apparatus including light-receiving elements, and may control an image displayed on the display apparatus based on the gaze information of the user from the image pickup apparatus. Specifically, in the display apparatus, a first field-of-view area at which the user gazes and a second field-of-view area other than the first field-of-view area are determined on the basis of the gaze information. The first field-of-view area and the second field-of-view area may be determined by the control unit of the display apparatus or may be determined by receiving those determined by an external control unit. In the display area of the display apparatus, the display resolution of the first field-of-view area may be controlled to be higher than the display resolution of the second field-of-view area. That is, the resolution of the second field-of-view area may be lower than that of the first field-of-view area.

The display area includes a first display area and a second display area different from the first display area. Based on the gaze information, an area of higher priority is determined from the first display area and the second display area. The first field-of-view area and the second field-of-view area may be determined by the control unit of the display apparatus or may be determined by receiving those determined by an external control unit. The resolution of an area of higher priority may be controlled to be higher than the resolution of an area other than the area of higher priority. In other words, the resolution of an area of a relatively low priority may be low.

Artificial intelligence (AI) may be used to determine the first field-of-view and the high-priority area. The AI may be a model configured to estimate the angle of gaze from the image of the eyeball and the distance to a target object located in the gaze direction, using the image of the eyeball and the actual direction of gaze of the eyeball in the image as teaching data. The AI program may be stored in the display apparatus, the image pickup apparatus, or an external apparatus. When the AI program is stored in the external apparatus, the AI program is transmitted to the display apparatus via communications.

In the case of controlling the display based on visual detection, smart glasses that further include an image pickup apparatus that captures an external image can be used. The smart glasses can display the captured external information in real time.

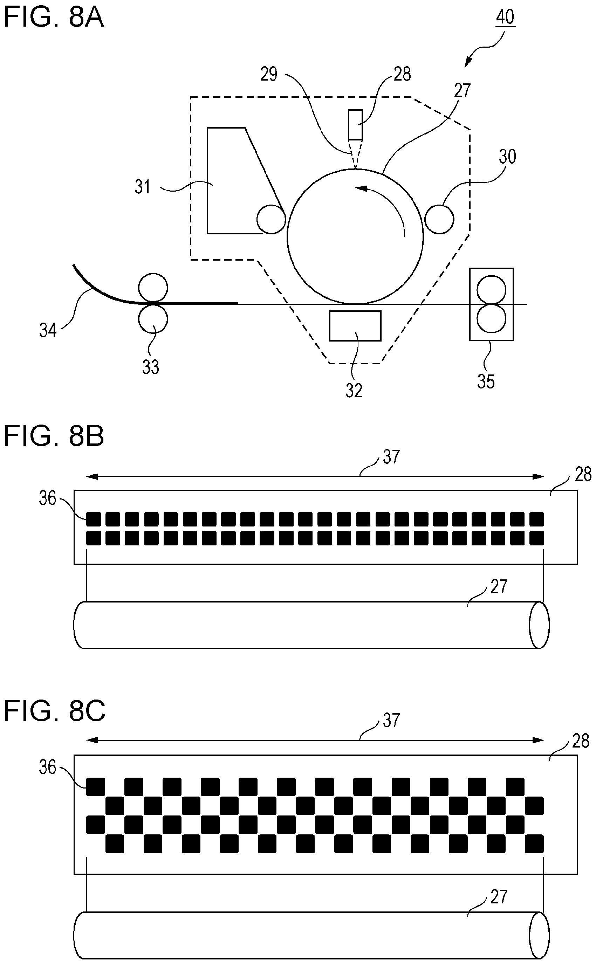

Fig. 8A is a schematic view of an example of an image-forming apparatus according to an embodiment of the present invention. An image-forming apparatus 40 is an electrophotographic image-forming apparatus and includes a photoconductor 27, an exposure light source 28, a charging unit 30, a developing unit 31, a transfer unit 32, a transport roller 33, and a fusing unit 35. The irradiation of light 29 is performed from the exposure light source 28 to form an electrostatic latent image on the surface of the photoconductor 27. The exposure light source 28 includes the organic light-emitting device according to the present embodiment. The developing unit 31 contains, for example, a toner. The charging unit 30 charges the photoconductor 27. The transfer unit 32 transfers the developed image to a recording medium 34. The transport roller 33 transports the recording medium 34. The recording medium 34 is paper, for example. The fusing unit 35 fixes the image formed on the recording medium 34.

Figs. 8B and 8C each illustrate the exposure light source 28 and are each a schematic view illustrating multiple light-emitting portions 36 arranged on a long substrate. Arrows 37 are parallel to the axis of the photoconductor and each represent the row direction in which the organic light-emitting devices are arranged. The row direction is the same as the direction of the axis on which the photoconductor 27 rotates. This direction can also be referred to as the long-axis direction of the photoconductor 27. Fig. 8B illustrates a configuration in which the light-emitting portions 36 are arranged in the long-axis direction of the photoconductor 27. Fig. 8C is different from Fig. 8B in that the light-emitting portions 36 are arranged alternately in the row direction in a first row and a second row. The first row and the second row are located at different positions in the column direction. In the first row, the multiple light-emitting portions 36 are spaced apart. The second row has the light-emitting portions 36 at positions corresponding to the positions between the light-emitting portions 36 in the first row. In other words, the multiple light-emitting portions 36 are also spaced apart in the column direction. The arrangement in Fig. 8C can be rephrased as, for example, a lattice arrangement, a staggered arrangement, or a checkered pattern.

As described above, the use of an apparatus including the organic light-emitting device according to the present embodiment enables a stable display with good image quality even for a long time.

### EXAMPLES

Examples will be described below. However, the present invention is not limited thereto.

### [Example 1 (Synthesis of Exemplified Compound D-1)]

Exemplified compound D-1 was synthesized according to the following scheme.

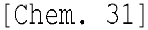

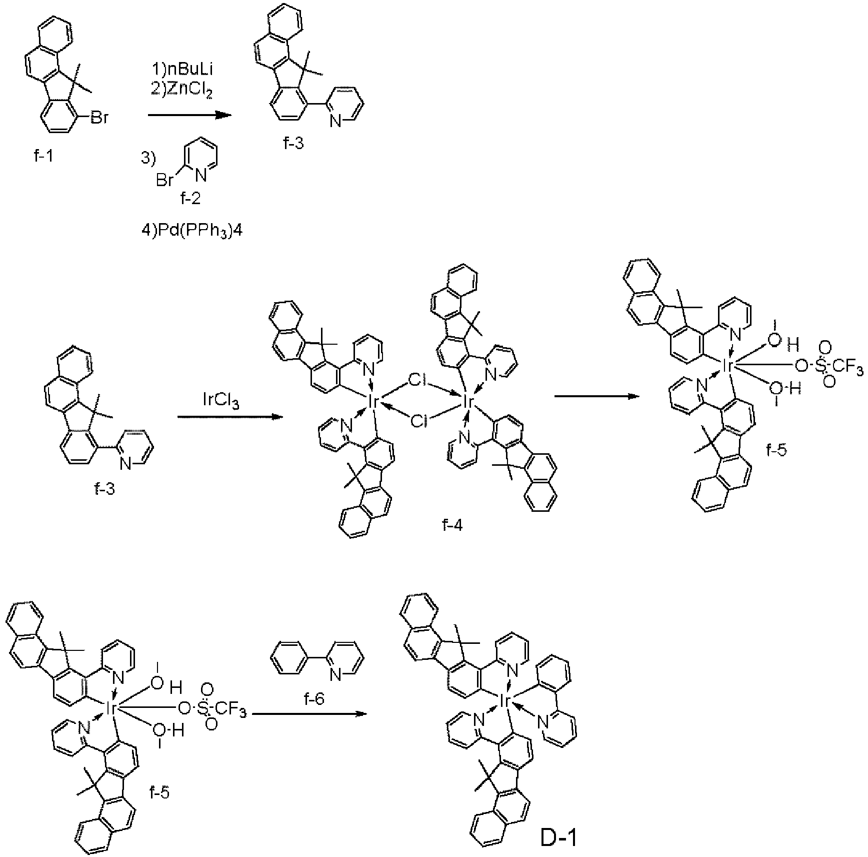

### (1) Synthesis of Compound f-3

The following reagents and solvents were placed in a 200-mL recovery flask.
Compound f-1: 6.46 g (20.0 mmol)
Sodium carbonate: 5.3 g (50.0 mmol)
THF: 90 ml
Water: 35 ml
Ethanol: 10 ml

The reaction solution was cooled to -78°C, and then 16.0 ml (25.0 mmol) of n-BuLi (1.56 M hexane solution) was added dropwise thereto. After stirring for 30 minutes, ZnCl₂ (2.0 M 2-methyltetrahydrofuran solution)) (15.0 mL, 30.0 mmol.) was added thereto. The mixture was stirred for 15 minutes. Thereafter, the reaction solution was brought to room temperature, and then 2.27 g (20.0 mmol) of f-2 and 578 mg of Pd(PPh₃)₄ were added thereto. The mixture was heated and stirred at 80°C for 18 hours. After the completion of the reaction, the mixture was extracted with toluene, and then the organic layer was concentrated to dryness. The resulting solid was purified by silica gel column chromatography (toluene-ethyl acetate mixture) to give 0.77 g (yield: 12%) of a transparent solid (f-3).

### (2) Synthesis of Compound f-4

The following reagents and solvents were placed in a 50-mL recovery flask.
Compound f-3: 3.21 g (10.0 mmol)
Iridium chloride hydrate: 0.80 g
Ethoxyethanol: 12 ml
Water: 4 ml

The reaction solution was heated and stirred at 130°C for 5 hours under a stream of nitrogen. After the completion of the reaction, the reaction solution was filtered, and then the resulting solid was washed on the filter with water and methanol to give 1.8 g of a yellow solid (f-4).

### (3) Synthesis of Compound f-5

The following reagents and solvents were placed in a 100-mL recovery flask.
Compound f-4: 1.74 (1.00 mmol)
Silver triflate: 0.514 g (2.00 mmol)
Methylene chloride: 30 ml
Methanol: 1.3 ml

The reaction solution was heated and stirred at room temperature for 6 hours under a stream of nitrogen. After the completion of the reaction, the solvents were removed from the reaction solution at 40°C to give 2.24 g of a yellowish brown solid (f-5).

### (4) Synthesis of Exemplified Compound D-1

The following reagents and solvent were placed in a 50-mL recovery flask.
Compound f-5: 1.20 g
Compound f-6: 0.16 g (1.00 mmol)
Ethanol: 50 ml

The reaction solution was heated and stirred at 90°C for 5 hours under a stream of nitrogen. After the completion of the reaction, the reaction solution was filtered, and then the resulting solid was washed on the filter with water and methanol. The resulting solid was purified by silica gel column chromatography (toluene-ethyl acetate mixture) to give 0.32 g (yield: 32%) of a yellow solid (exemplified compound D-1).

Exemplified compound D-1 was subjected to mass spectrometry with MALDI-TOF-MS (Autoflex LRF, manufactured by Bruker).

### [MALDI-TOF-MS]

### Measured value: m/z = 987, calculated value: C₅₉H₄₄IrN₃ = 987

### [Examples 2 to 29 (Syntheses of Exemplified Compounds)]

As presented in Tables 4 to 7, exemplified compounds of Examples 2 to 29 were synthesized as in Example 1, except that raw material f-1 of Example 1 was changed to raw material 1, raw material f-2 to raw material 2, and raw material f-6 to raw material 3. The resulting exemplified compounds were subjected to mass spectrometry as in Example 1, and the measured values of m/z are also presented.

### [Table 4]

**Table 4**

| Example | Exemplified compound | Raw material 1 | Raw material 2 | Raw material 3 | m/z |
|---|---|---|---|---|---|
| 2 | D-2 | 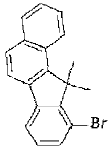 | 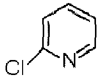 | 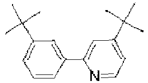 | 1096 |
| 3 | D-11 | 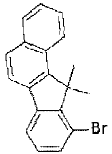 | 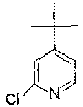 | 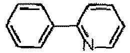 | 1096 |
| 4 | D-12 | 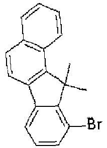 | 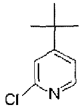 | 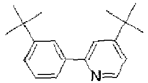 | 1208 |
| 5 | D-13 | 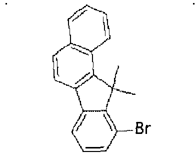 | 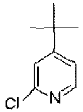 | 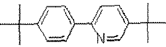 | 1208 |
| 6 | E-1 | 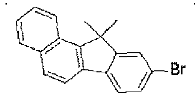 | 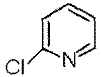 | 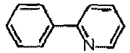 | 987 |
| 7 | E-2 | 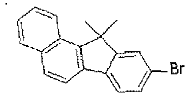 | 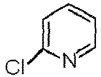 | 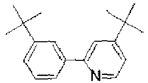 | 1096 |
| 8 | E-11 | 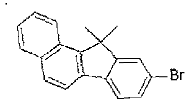 | 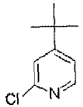 | 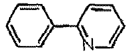 | 1096 |
| 9 | E-12 | 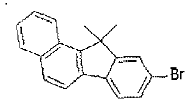 | 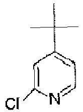 | 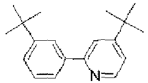 | 1208 |
| 10 | E-14 | 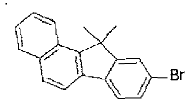 | 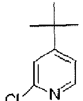 | 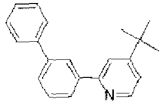 | 1228 |

11006239WO01

**[Table 5]**

| Table 5 | | | | | |
|---|---|---|---|---|---|
| Example | Exemplified compound | Raw material 1 | Raw material 2 | Raw material 3 | m/z |
| 11 | F-1 | 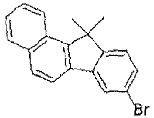 | 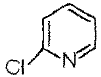 | 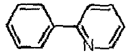 | 987 |
| 12 | F-11 | 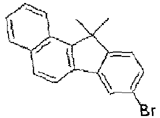 | 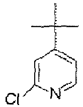 | 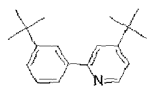 | 1208 |
| 13 | G-1 | 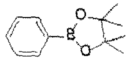 | 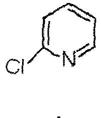 | 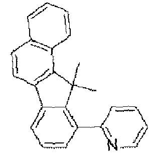 | 818 |
| 14 | G-2 | 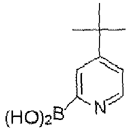 | 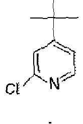 | 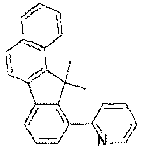 | 1042 |
| 15 | G-7 | 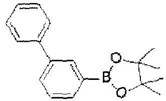 | 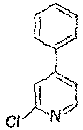 | 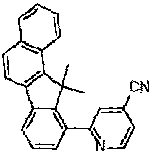 | 1157 |
| 16 | G-11 | 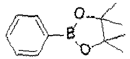 | 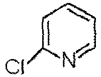 | 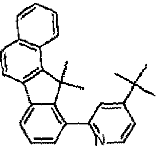 | 874 |
| 17 | G-12 | 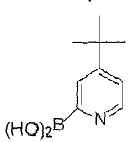 | 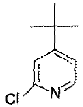 | 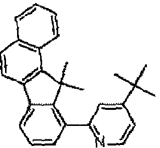 | 1098 |

### [Table 6]

**Table 6**

| Example | Exemplified compound | Raw material 1 | Raw material 2 | Raw material 3 | m/z |
|---|---|---|---|---|---|
| 18 | H-1 | 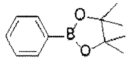 | 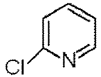 | 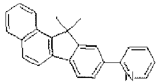 | 818 |
| 19 | H-2 | 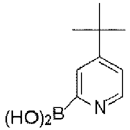 | 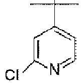 | 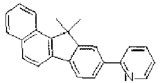 | 1042 |
| 20 | H-6 | 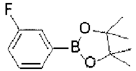 | 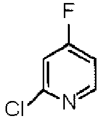 | 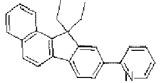 | 918 |
| 21 | H-11 | 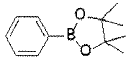 | 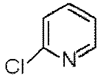 | 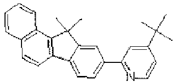 | 874 |
| 22 | H-12 | 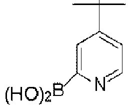 | 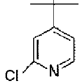 | 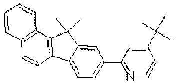 | 1098 |
| 23 | I-1 | 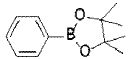 | 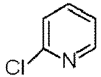 | 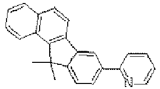 | 818 |
| 24 | I-2 | 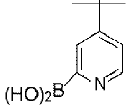 | 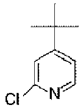 | 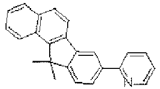 | 1042 |
| 25 | I-11 | 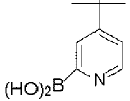 | 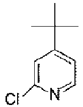 | 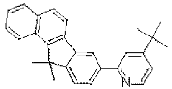 | 1098 |
| 26 | I-14 | 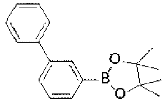 | 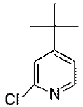 | 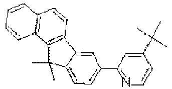 | 1082 |

### [Table 7]

**Table 7**

| Example | Exemplified compound | Raw material 1 | Raw material 2 | Raw material 3 | m/z |
|---|---|---|---|---|---|
| 27 | K-13 | 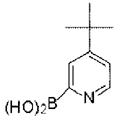 | 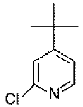 | 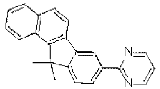 | 822 |
| 28 | L-6 | 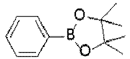 | 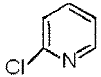 | 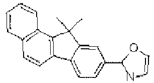 | 811 |
| 29 | L-10 | 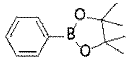 | 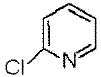 | 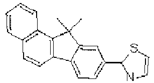 | 827 |

### [Example 30 (Synthesis of Exemplified Compound D-16)]

Exemplified compound D-16 was synthesized according to the following scheme. Intermediate f-4 was synthesized in the same manner as in Example 1 using raw material f-3.

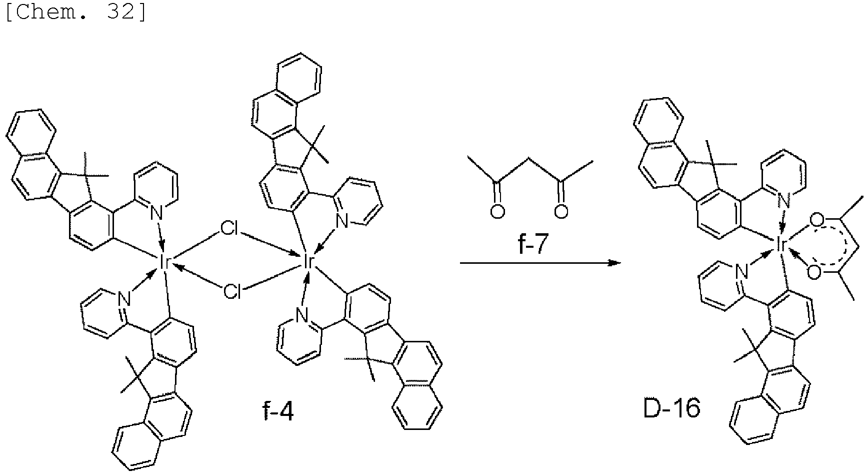

The following reagents and solvents were placed in a 100-mL recovery flask.
Compound f-4: 1.73 g (1.00 mmol)
Compound f-7: 0.40 g (4.00 mmol)
Sodium carbonate: 1.06 g (10.0 mmol)
Ethoxyethanol: 33 ml
Water: 12 ml

The reaction solution was heated and stirred at 100°C for 7 hours under a stream of nitrogen. After cooling, methanol was added thereto. The mixture was filtered and then washed with methanol to give 0.36 g (yield: 39%) of a yellow solid (D-16).

The exemplified compound D-16 was subjected to mass spectrometry in the same manner as in Example 1.

### [MALDI-TOF-MS]

### Measured value: m/z = 933, calculated value: C₅₃H₄₆IrO₂N₃ = 933

### [Examples 31 to 35 (Syntheses of Exemplified Compounds)]

As presented in Table 8, exemplified compounds of Examples 31 to 35 were synthesized as in Example 30, except that raw material f-3 of Example 30 was changed to raw material 1 and raw material f-7 to raw material 2. The resulting exemplified compounds were subjected to mass spectrometry as in Example 30, and the measured values of m/z are also presented.

### [Table 8]

**Table 8**

| Example | Exemplified compound | Raw material 1 | Raw material 2 | m/z |
|---|---|---|---|---|
| 31 | D-17 | 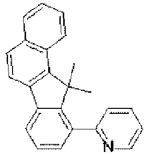 | 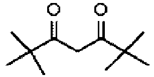 | 1016 |
| 32 | D-20 | 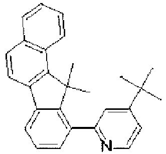 | 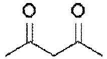 | 1128 |
| 33 | E-16 | 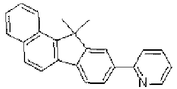 | 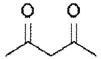 | 1044 |
| 34 | F-17 | 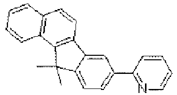 | 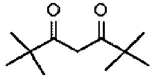 | 1016 |
| 35 | F-20 | 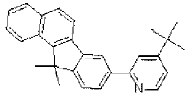 | 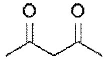 | 1128 |

### [Example 36 (Synthesis of Exemplified Compound J-1)]

Exemplified compound J-1 was synthesized according to the following scheme.

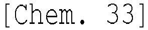

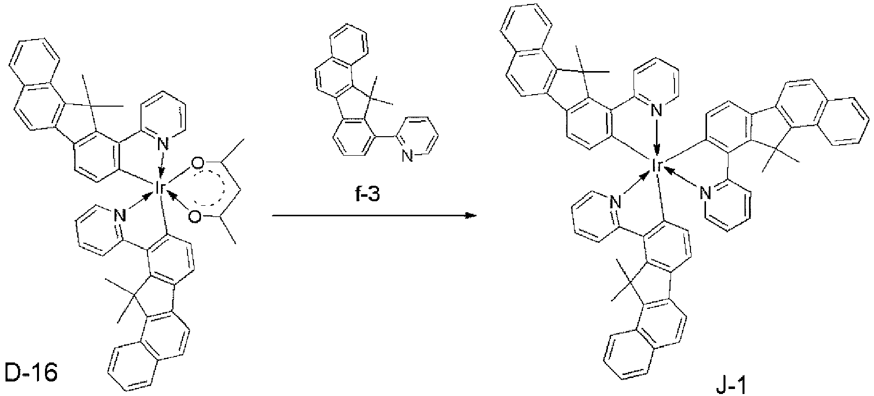

The following reagents and solvent were placed in a 100-mL recovery flask.
Compound D-16: 0.93 g (1.00 mmol)
Compound f-3: 0.80 g (2.50 mmol)
Sodium carbonate: 1.06 g (10.0 mmol)
Glycerol: 30 ml

The reaction solution was subjected to degassing with nitrogen and then heated and stirred at 180°C for 7 hours. After cooling, methanol was added thereto. The mixture was filtered and then washed with methanol. The resulting solid was purified by silica gel column chromatography (toluene-ethyl acetate mixture) to give 0.17 g (yield: 15%) of a yellow solid (exemplified compound J-1).

The exemplified compound J-1 was subjected to mass spectrometry in the same manner as in Example 1.

### [MALDI-TOF-MS]

### Measured value: m/z = 1,153, calculated value: C₇₂H₅₄IrN₃ = 1,153

### [Examples 37 to 39 (Syntheses of Exemplified Compounds)]

As presented in Table 9, exemplified compounds of Examples 37 to 39 were synthesized as in Example 36, except that raw material D-16 of Example 36 was changed to raw material 1 and raw material f-3 to raw material 2. The resulting exemplified compounds were subjected to mass spectrometry as in Example 36, and the measured values of m/z are also presented.

### [Table 9]

**Table 9**

| Example | Exemplified compound | Raw material 1 | Raw material 2 | m/z |
|---|---|---|---|---|
| 37 | J-2 | D-20 | 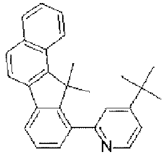 | 1321 |
| 38 | J-6 | E-16 | 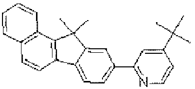 | 1321 |
| 39 | J-11 | F-20 | 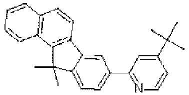 | 1321 |

### [Example 40]

An organic light-emitting device having a bottom-emission structure was produced in which an anode, a hole injection layer, a hole transport layer, an electron-blocking layer, a light-emitting layer, a hole-blocking layer, an electron transport layer, an electron injection layer, and a cathode were sequentially formed on a substrate.

An ITO film was formed on a glass substrate and subjected to desired patterning to form an ITO electrode (anode). The ITO electrode had a thickness of 100 nm. The substrate on which the ITO electrode had been formed in this way was used as an ITO substrate in the following steps. Next, vacuum vapor deposition was performed by resistance heating in a vacuum chamber at 1.3 × 10⁻⁴ Pa to successively form organic compound layers and an electrode layer presented in Table 10 on the ITO substrate. Here, the opposing electrode (metal electrode layer, cathode) had an electrode area of 3 mm².

### [Table 10]

**Table 10**

| | Material | | Thickness (nm) |
|---|---|---|---|
| Cathode | Al | | 100 |
| Electron injection layer (EIL) | LiF | | 1 |
| Electron transport layer (ETL) | ET2 | | 20 |
| Hole-blocking layer (HBL) | ET12 | | 20 |
| Light-emitting layer (EML) | Host material | Dopant material | 35 |
| | Q-1-24 | D-2 | |
| Light-emitting layer, % by mass | 85 | 15 | |
| Electron-blocking layer (EBL) | HT7 | | 10 |
| Hole transport layer (HTL) | HT2 | | 20 |
| Hole injection layer (HIL) | HT16 | | 5 |

The characteristics of the resulting device were measured and evaluated. The efficiency of the light-emitting device was 66 cd/A. The device was subjected to a continuous operation test at a current density of 50 mA/cm². The time when the percentage of luminance degradation reached 5% was measured. In Examples 41 to 47, the time when the percentage of luminance degradation reaches 5% is indicated by the ratio when the time in this example is 1.0.

With regard to measurement instruments, in this example, the current-voltage characteristics were measured with a Hewlett-Packard 4140B microammeter, and the luminance was measured with a Topcon BM7.

### [Examples 41 to 47]

Organic light-emitting devices were produced in the same manner as in Example 40, except that the materials were appropriately changed to materials presented in Table 11. Compound Q-2-1 is the following compound.

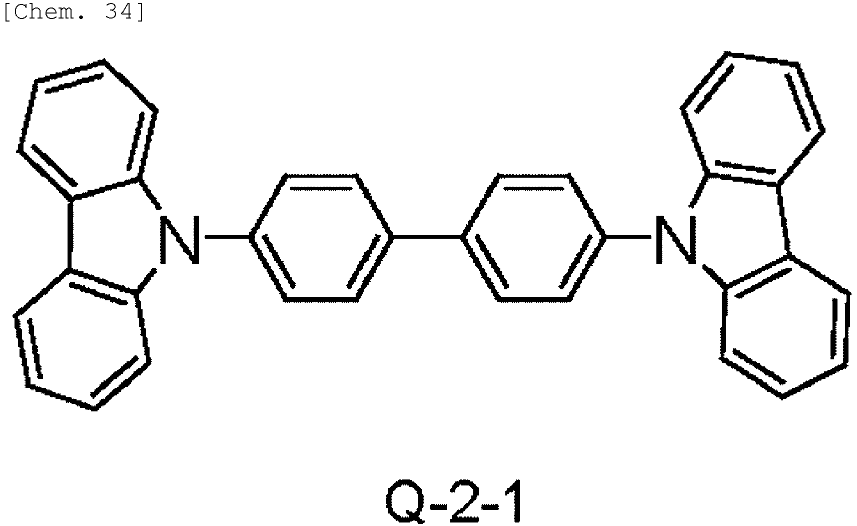

The resulting devices were evaluated in the same manner as in Example 40. The time when the percentage of luminance degradation reaches 5% is indicated by the ratio when the time in Example 40 is 1.0. Table 11 presents the measurement results.

### [Table 11]

**Table 11**

| | EML | | Efficiency (Cd/A) | Ratio of luminance degradation |
|---|---|---|---|---|
| | Host material | Dopant material | | |
| Example 41 | Q-1-23 | D-11 | 65 | 1.1 |
| Example 42 | Q-1-24 | E-12 | 68 | 1.1 |
| Example 43 | Q-1-16 | F-11 | 64 | 1.0 |
| Example 44 | Q-1-10 | F-1 | 63 | 0.9 |
| Example 45 | Q-1-18 | D-17 | 65 | 0.8 |
| Example 46 | Q-2-1 | D-11 | 56 | 0.3 |
| Example 47 | HT19 | F-11 | 58 | 0.4 |

Table 11 indicates that the light-emitting devices according to the present invention emit light with high efficiency. In the light-emitting devices of Examples 40 to 45, since the host material is a hydrocarbon compound, the interaction with the compound represented by general formula

[1] is strong, the luminous efficiency is high, and the stability of the host material is good, and thus the luminance degradation is small. From the above, it is understood that a device having high efficiency and excellent durability characteristics can be provided by using the compound represented by general formula [1] as a light-emitting dopant and selecting a preferable host material.

### [Example 48]

An organic light-emitting device was produced in the same manner as in Example 40, except that the compounds and thicknesses were changed to those presented in Table 12.

### [Table 12]

**Table 12**

| | Material | | | Thickness (nm) |
|---|---|---|---|---|
| Cathode | Al | | | 100 |
| Electron injection layer (EIL) | LiF | | | 1 |
| Electron transport layer (ETL) | ET2 | | | 20 |
| Hole-blocking layer (HBL) | ET12 | | | 20 |
| Light-emitting layer (EML) | Host material | Assist material | Dopant material | 30 |
| | Q-1-19 | S-1-25 | D-11 | |
| Light-emitting layer, % by mass | 60 | 30 | 10 | |
| Electron-blocking layer (EBL) | HT7 | | | 15 |
| Hole transport layer (HTL) | HT2 | | | 20 |
| Hole injection layer (HIL) | HT16 | | | 5 |

The resulting device was evaluated in the same manner as in Example 40. The efficiency of the light-emitting device was 66 cd/A. In Examples 49 to 56, the time when the percentage of luminance degradation reaches 5% is indicated by the ratio when the time in this example is 1.0.

### [Examples 49 to 56]

Organic light-emitting devices were produced in the same manner as in Example 48, except that the materials were appropriately changed to materials presented in Table 13. The resulting devices were evaluated in the same manner as in Example 48. The time when the percentage of luminance degradation reaches 5% is indicated by a ratio when the time when the percentage of luminance degradation in Example 48 reaches 5% is set to 1.0. Table 13 presents the measurement results.

### [Table 13]

**Table 13**

| | EML | | | Efficiency (Cd/A) | Ratio of luminance degradation |
|---|---|---|---|---|---|
| | Host material | Assist material | Dopant material | | |
| Example 49 | Q-1-22 | S-1-25 | D-2 | 65 | 1.1 |
| Example 50 | Q-1-19 | S-1-4 | G-11 | 66 | 1.2 |
| Example 51 | Q-1-24 | S-1-25 | H-11 | 68 | 0.8 |
| Example 52 | 0-1-20 | S-2-3 | I-11 | 61 | 1.1 |
| Example 53 | Q-1-18 | S-2-8 | G-12 | 66 | 0.9 |
| Example 54 | Q-2-1 | S-1-4 | I-14 | 57 | 0.2 |
| Example 55 | HT-12 | S-1-25 | H-6 | 56 | 0.3 |
| Example 56 | HT-13 | S-1-4 | J-11 | 55 | 0.5 |

Table 13 indicates that the light-emitting devices according to the present invention emit light with high efficiency. In the light-emitting devices of Examples 48 to 53, since the host material is a hydrocarbon compound, the interaction with the compound represented by general formula [1] is strong, the luminous efficiency is high, and the stability of the host material is good, and thus the luminance degradation is small. From the above, it is understood that a device having high efficiency and excellent durability characteristics can be provided by using the compound represented by general formula [1] as a light-emitting dopant and selecting a preferable host material.

The present invention is not limited to the above-described embodiments, and various changes and modifications can be made without departing from the spirit and scope of the present invention. Therefore, the following claims are attached in order to make the scope of the present invention public.

This application claims priority based on Japanese Patent Application No. 2021-166627 filed October 11, 2021, which is hereby incorporated by reference herein in its entirety.

### Reference Signs List

- 1: interlayer insulating layer
- 2: first electrode
- 3: insulating layer
- 4: organic compound layer
- 5: second electrode
- 6: protective layer
- 7: color filter
- 10: subpixel
- 11: substrate
- 12: insulating layer
- 13: gate electrode
- 14: gate insulating film
- 15: semiconductor layer
- 16: drain electrode
- 17: source electrode
- 18: TFT
- 19: insulating film
- 20: contact hole
- 21: anode
- 22: organic compound layer
- 23: cathode
- 24: first protective layer
- 25: second protective layer
- 26: organic light-emitting device
- 100: display apparatus

## Claims

1. An organic compound represented by the following general formula [1]: 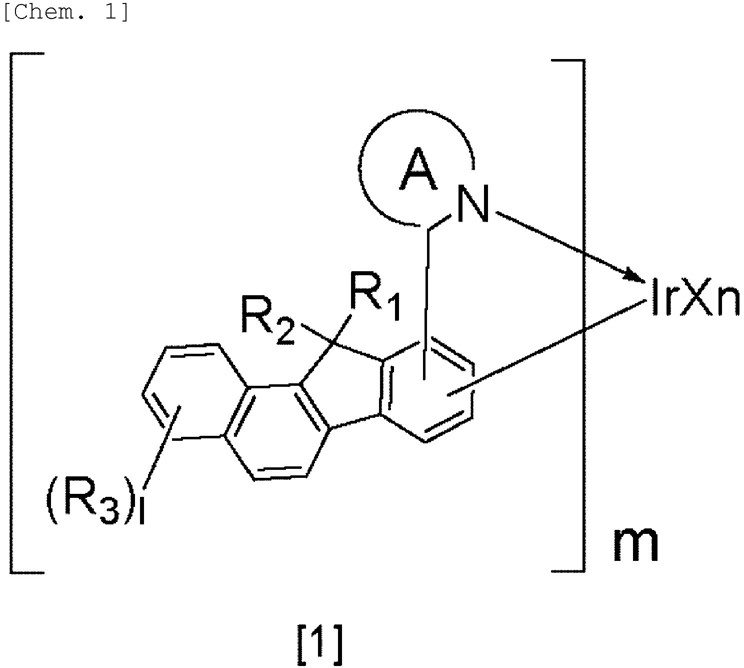 where in formula [1], R₁ and R₂ are each independently selected from a hydrogen atom, a deuterium atom, a substituted or unsubstituted alkyl group, a substituted or unsubstituted silyl group, a substituted or unsubstituted aryl group, and
a substituted or unsubstituted heterocyclic group,
each R₃ is independently selected from a deuterium atom, a halogen atom, a cyano group, a substituted or unsubstituted alkyl group, a substituted or unsubstituted alkoxy group, a substituted or unsubstituted silyl group, a substituted or unsubstituted aryl group, and a substituted or unsubstituted heterocyclic group, l is an integer of 0 or more and 8 or less,
m is an integer of 1 or more and 3 or less, n is an integer of 0 or more and 2 or less, provided that m + n is 3,
X is a bidentate ligand, a partial structure IrX is any of structures represented by the following general formulae [2] and [3]: 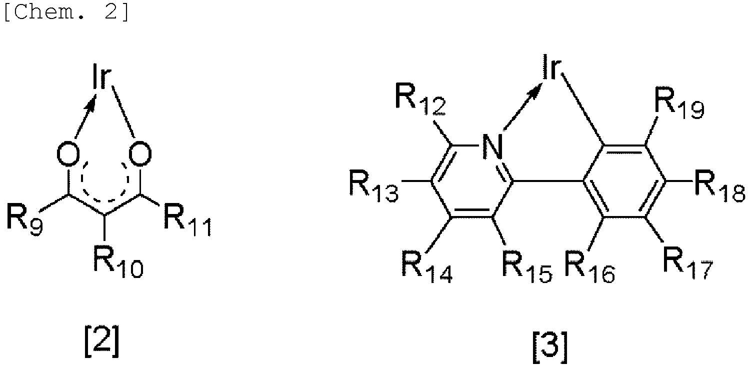 where in formula [2] or [3], R₉ to R₁₉ are each independently selected from a hydrogen atom, a deuterium atom,
a halogen atom, a cyano group, a substituted or unsubstituted alkyl group, a substituted or unsubstituted alkoxy group, a substituted or unsubstituted silyl group, a substituted or unsubstituted aryl group, and a substituted or unsubstituted heterocyclic group, adjacent groups of R₁₆ to R₁₉ are optionally taken together to form a ring, and
a ring A is any of structures represented by the following general formulae [4] to [7]: 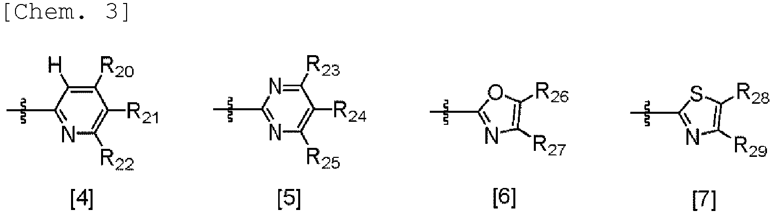 where in formulae [4] to [7], R₂₀ to R₂₉ are each independently selected from a hydrogen atom, a deuterium atom, a halogen atom, a cyano group, a substituted or unsubstituted alkyl group, a substituted or unsubstituted alkoxy group, a substituted or unsubstituted silyl group, a substituted or unsubstituted aryl group, and a substituted or unsubstituted heterocyclic group.

2. The organic compound according to Claim 1, wherein the organic compound is represented by the following general formula [10]:

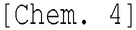

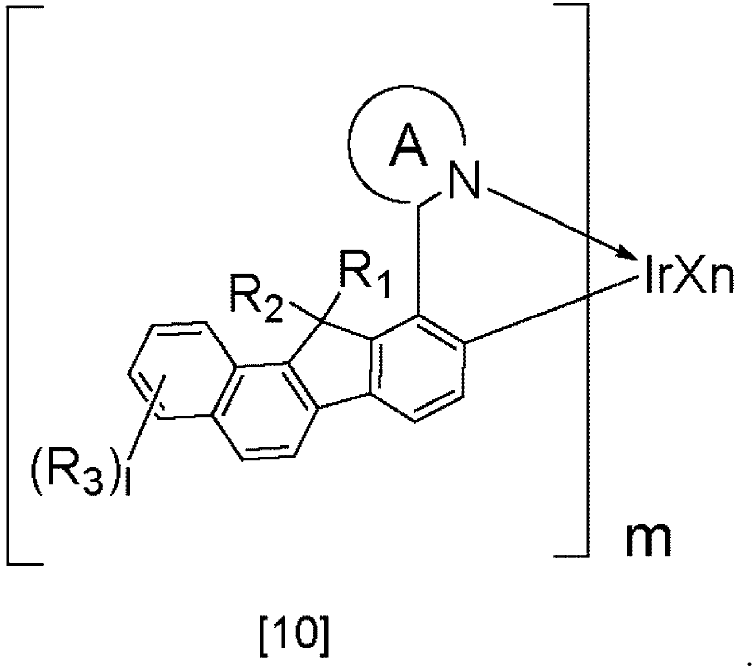

3. The organic compound according to Claim 1, wherein the organic compound is represented by the following general formula [11]:

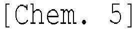

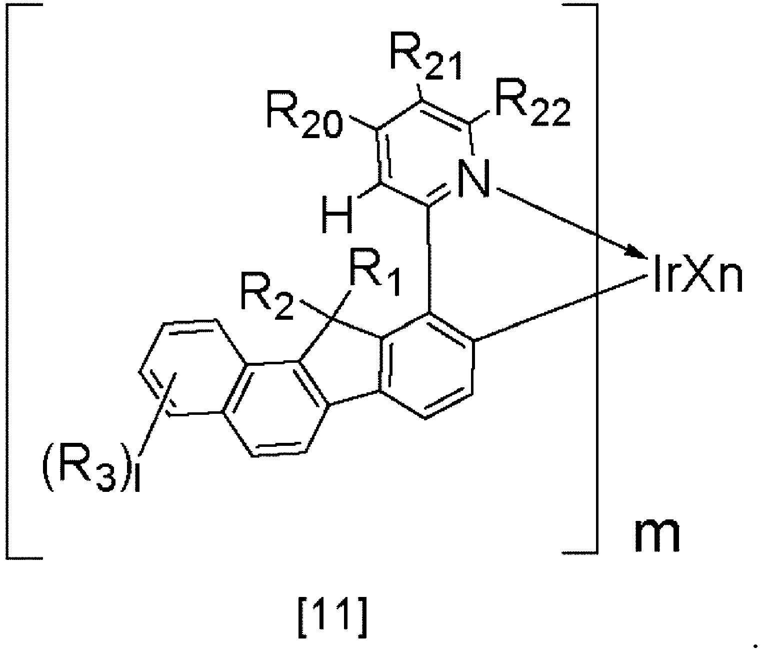

4. The organic compound according to any one of Claims 1 to 3, wherein each of R₁ and R₂ is a substituted or unsubstituted alkyl group.

5. The organic compound according to any one of Claims 1 to 4, wherein at least one of R₂₀ to R₂₉ is a tertiary alkyl group.

6. The organic compound according to Claim 5, wherein the tertiary alkyl group is a tert-butyl group.

7. An organic light-emitting device, comprising a first electrode, a second electrode, and an organic compound layer disposed between the first electrode and the second electrode,
wherein at least one layer of the organic compound layer contains the organic compound according to any one of Claims 1 to 6.

8. The organic light-emitting device according to Claim 7, wherein the layer containing the organic compound is a light-emitting layer.

9. The organic light-emitting device according to Claim 8, wherein the light-emitting layer contains a first compound.

10. The organic light-emitting device according to Claim 9, wherein the first compound is a hydrocarbon compound.

11. The organic light-emitting device according to Claim 9 or 10, wherein the first compound contains no SP³ carbon.

12. The organic light-emitting device according to any one of Claims 9 to 11, wherein the first compound has a skeleton containing at least one of a chrysene ring, a picene ring, a phenanthrene ring, a triphenylene ring, and a fluorene ring.

13. The organic light-emitting device according to any one of Claims 8 to 12, wherein the light-emitting layer contains a third compound.

14. The organic light-emitting device according to Claim 13, wherein the third compound is a compound partially including any of the following structures: 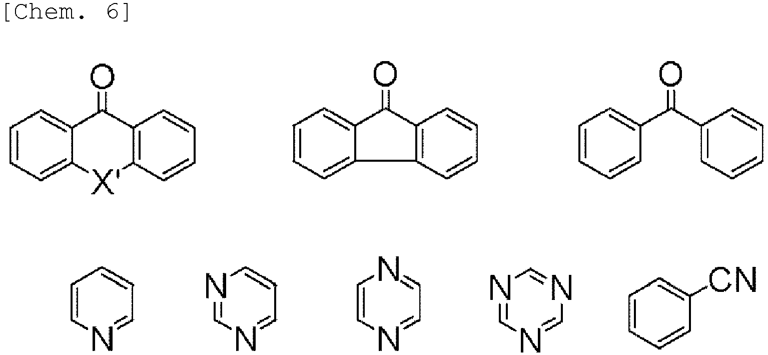 (where in the structures, X' is oxygen, sulfur, or a substituted or unsubstituted carbon atom).

15. A display apparatus, comprising multiple pixels, at least one of the multiple pixels including the organic light-emitting device according to any one of Claims 8 to 14 and a transistor coupled to the organic light-emitting device.

16. A photoelectric conversion apparatus, comprising an optical unit including multiple lenses, an image pickup device configured to receive light passing through the optical unit, and a display unit configured to display an image captured by the image pickup device,
wherein the display unit includes the organic light-emitting device according to any one of Claims 8 to 14.

17. An electronic apparatus, comprising a display unit including the organic light-emitting device according to any one of Claims 8 to 14, a housing provided with the display unit, and a communication unit disposed in the housing and configured to communicate with an outside.

18. A lighting apparatus, comprising a light source including the organic light-emitting device according to any one of Claims 8 to 14, and a light diffusion unit or an optical filter configured to transmit light emitted from the light source.

19. A moving object, comprising a lighting unit including the organic light-emitting device according to any one of Claims 8 to 14, and a body provided with the lighting unit.

20. An exposure light source for an electrophotographic image-forming apparatus, comprising the organic light-emitting device according to any one of Claims 8 to 14.
